## Europäisches Patentamt

## European Patent Office

## Office européen des brevets

(11) Publication number: **0 066 068**
**B1**

## EUROPEAN PATENT SPECIFICATION

(45) Date of publication of patent specification: **02.11.88**

(51) Int. Cl.⁴: **H 01 L 27/06, H 01 L 21/82**

(21) Application number: **82103172.1**

(22) Date of filing: **15.04.82**

(54) Structure and process for fabrication of stacked complementary MOS field effect transistor devices.

(30) Priority: **19.05.81 US 265001**

(43) Date of publication of application:
**08.12.82 Bulletin 82/49**

(45) Publication of the grant of the patent:
**02.11.88 Bulletin 88/44**

(84) Designated Contracting States:
**DE FR GB**

(56) References cited:
**US-A-3 356 858**
**US-A-3 585 088**
**US-A-4 124 807**
**ELECTRON DEVICE LETTERS, vol. EDL-1, no. 6, June 1980, pages 117-118, New York, US; J.F.GIBBONS et al.: "One-gate-wide CMOS inverter on laser-recrystallized polysilicon"**
**ELECTRONICS INT., vol. 52, no. 24, 22nd November 1979, pages 39-40; J.G.POSA: "All-silicon devices will match SOS in performance"**
**INTER ELECTRONIQUE, vol. 26, no. 29, 26th November 1971, pages 32-39; J.P.DELLA MUSSIA: "En 1972, la technique C-MOS marquera pour les circuits intégrés le début d'une ère nouvelle"**

(73) Proprietor: **International Business Machines Corporation**
**Old Orchard Road**
**Armonk, N.Y. 10504 (US)**

(72) Inventor: **Bansal, Jai Pal**
**9610 Gladstone Street**
**Manassas, VA 22110 (US)**
Inventor: **Bertin, Claude Louis**
**33 Pheasant Way**
**S. Burlington, VT (US)**
Inventor: **Troutman, Ronald Roy**
**7 Rustic Drive**
**Essex Junction, VT 05452 (US)**

(74) Representative: **Gaugel, Heinz, Dipl.-Ing.**
**Schönaicher Strasse 220**
**D-7030 Böblingen (DE)**

(56) References cited:
**IEEE ELECTRON DEVICE LETTERS, vol. EDL-2, no. 10, October 1981, pages 250-251, New York, US; J.P.COLINGE et al.: "A high density CMOS inverter with stacked transistors"**
**IBM Technical Disclosure Bulletin, Vol. 15, No. 9, (1973, 02), 2856-7**

Courier Press, Leamington Spa, England.

## Description

The invention relates to stacked CMOS devices, the individual complementary FET devices of which share a common gate sandwiched between them.

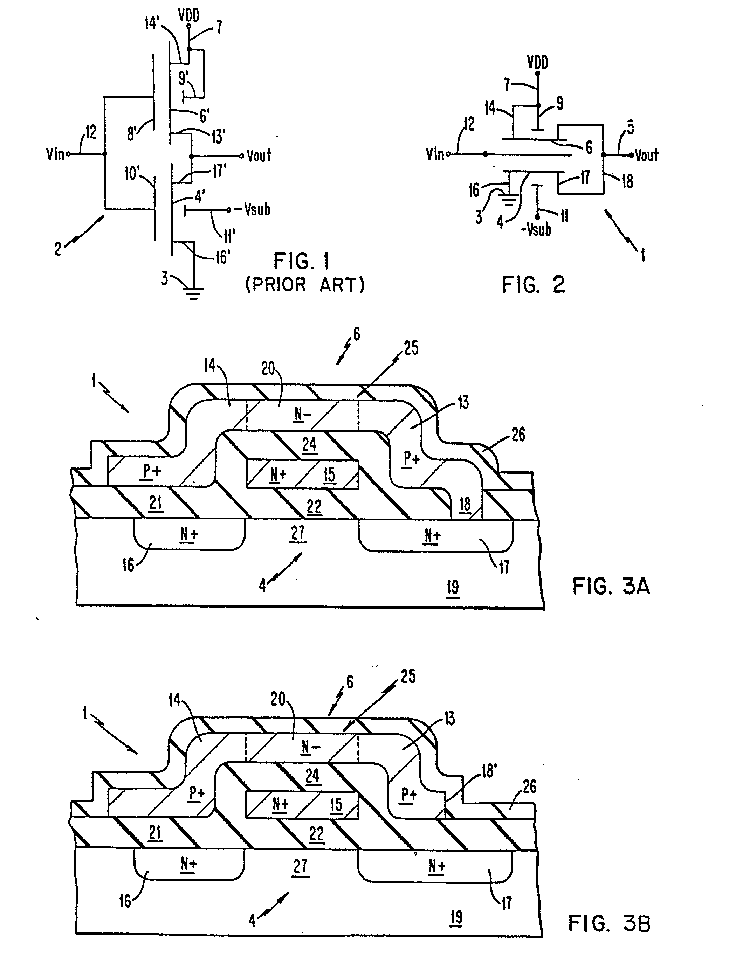

IGFET inverter circuits employing a pair of complementary IGFET devices (CMOS) have been widely employed in the prior art, as is shown in Fig. 1. The CMOS inverter 2 shown in Fig. 1 includes an N channel enhancement mode transistor 4' connected to the least positive voltage supply 3 and a P channel enhancement transistor 6' connected to the most positive voltage supply 7, with the common drains being the output 5. The gate 8' of the P channel device 6' and the gate 10' of the N channel device 4' are connected together and receive the input signal at the terminal 12. When the input signal at 12 is down, the N channel enhancement mode device 4' is turned off and the P channel enhancement mode device 6' is turned on so that the output at 5 is at the level of the most positive supply voltage 7. When the input signal at the input 12 is high, the N channel device 4' is on and the P channel device 6' is off, resulting in the output 5 being at the level of the least positive supply voltage 3. Since one of the devices 4' or 6' of the pair in the circuit 2 is always off during their steady state, this type of circuit dissipates power only during its switching transients.

The principal technique for forming CMOS circuits in the prior art is to select a particular conductivity type substrate, for example an N-type substrate and then form first channel type devices, in this example P channel type devices by directly depositing P-type doped regions as the source and drain of the P channel devices into the N-type substrate. Then to form the other channel type or N channel devices, a relatively large island structure had to be formed in the substrate, in this example, for N channel devices in an N-type substrate, a P-type island would have to be formed and then the N-type conductivity source and drain regions be subsequently formed in the P-type island region. Only in this manner could both channel types of FET devices be formed in the same conductivity type semiconductor substrate. Although CMOS circuits having useful properties could be formed with this technique, there were significant accompanying disadvantages, namely that the island region formed in the semiconductor substrate took up a substantially larger area than did the actual FET device formed within it and secondly that the island structure would form parasitic bipolar transistors with other adjacent structures in the semiconductor substrate, producing unwanted electrical characteristics in the overall circuit. The paired wiring of gates for the N channel and P channel devices in conventional CMOS technology consumes considerable silicon real estate.

A suggestion for a solution to this problem was made by K. E. Kroell in his article "Integrated CMOS Structure," in the IBM Technical Disclosure Bulletin, Vol. 15, No. 9, February 1973, pp. 2856-2857, wherein he describes a shared gate, stacked CMOS structure wherein a pair of oppositely conductive FETs are superimposed upon each other so that the semiconductor space is required for only one MOSFET device. Kroell describes an N channel FET device being formed in a P-type silicon substrate by diffusing N-type source and drain regions directly into the substrate. After covering the channel region with a gate oxide insulator, Kroell deposits a metallization layer of temperature resistant metal and etches a conductor pattern for the common gate electrode and the remaining source and drain contacts for both the N channel device already formed in the substrate and the P channel device to be formed on top of the N channel device. Kroell then deposits a second gate insulating layer on top of the conductive metal gate already deposited on the channel of the N channel device, and then deposits a silicon layer of N-type conductivity on top of the assembly. Kroell then forms the P-type source and drain regions in the upper, N-type silicon layer by either diffusion or ion implantation processes, thereby forming a P channel device which is stacked on top of the N channel device and shares a common gate electrode.

The stacked CMOS structure disclosed by Kroell has a number of practical limitations in its operating characteristics, its amenability to large scale integrated circuit layouts, and its method of fabrication. For example, the N channel device described by Kroell is not self-aligned with respect to its gate. Furthermore, some refractory metals described by Kroell in his structure, such as molybdenum, have serious corrosion problems. With respect to Kroell's P channel device, it too is not self-aligned with its gate. Furthermore, photolithographic tolerances will limit the minimum size of the device since there are two alignment steps which are required in determining the channel length of the P channel device. Furthermore, the wirability of devices formed with Kroell's technique is limited due to the single level of interconnection using refractory metal, which he discloses. Still further, the P channel device formed by Kroell has a poor hole mobility and a high junction leakage characteristic because of its fabrication in polycrystalline silicon, as is implied by Kroell. Finally, there are fabrication difficulties which could lead to gate integrity problems.

The invention as claimed is intended to remedy these drawbacks. It solves the problem of how to design a stacked CMOS device structure which is more amenable to layouts in a large scale integrated circuit and of how to design a process which produces CMOS devices and circuits without excessive area consumption and parasitic effects.

A method is disclosed for fabricating series and/or parallel connected P channel and N channel FET devices topologically connected in a CMOS configuration, where the individual FET devices share a common gate sandwiched between them, forming a five terminal device. A new device structure and complementary MOSFET circuitry is also disclosed. The disclosed process produces devices and circuits which overcome the main disadvantage of prior art CMOS transistors, namely excessive area consumption and parasitic effects. Other advantages of the invention include both the N channel and P channel devices being self-aligned to the same gate electrode. Furthermore, as many as three different levels of wiring are available, namely the N+ polysilicon gate layer, the P-type polysilicon laser annealed silicon (LAS) layer, and the aluminum layer. Still other advantages of the invention include a better mobility for the P channel device comparable to that of P channel devices fabricated in bulk monocrystalline silicon. The mutually self-aligned P channel and N channel devices provide less overlap capacitance, a better control of the width to length ratio, a smaller area for device layout, and enable a direct contact between the N+ diffusion and the P+ laser annealed silicon layer. Furthermore, the process sequence disclosed enables all polycrystalline silicon regions to remain connected to the substrate during the laser annealing operation, thereby insuring a more uniform recrystallization of the polycrystalline silicon layers. In summary, the resulting device and fabrication process provides a substantial improvement over prior art CMOS technology.

Ways of carrying out the invention are described in detail below with reference to drawings, in which:

Fig. 1 is a schematic electric diagram of a conventional CMOS inverter.

Fig. 2 is an electrical schematic diagram of the stacked CMOS device.

Fig. 3a is a cross-sectional view of the stacked CMOS device where the drain of the P channel device is connected to the drain of the N channel device.

Fig. 3b is a cross-sectional view of a stacked CMOS device not claimed where the laser annealed silicon (LAS) layer of the P channel device is physically separated from the substrate containing the N channel device.

Figs. 4 through 17 illustrate the sequence of process steps to fabricate the stacked CMOS device.

Fig. 18a is a plan view of the stacked CMOS device for Fig. 3a.

Fig. 18b is a plan view of the stacked CMOS device for Fig. 3b.

Fig. 19 is an electrical schematic diagram of the stacked CMOS device when considered as a five terminal device.

Fig. 20 is an electrical schematic of a conventional CMOS flip-flop.

Fig. 21 is an electrical schematic of a flip-flop circuit embodied in the stacked CMOS devices.

Fig. 22 is an electrical schematic of a conventional three input NAND logic function embodied in conventional CMOS devices.

Fig. 23 is a three input NAND logic function embodied in stacked CMOS devices.

Fig. 24 is a physical layout of the circuit of Fig. 23.

Fig. 25 is an electrical circuit schematic of a conventional NOR logic function embodied in conventional CMOS devices.

Fig. 26 illustrates a three input NOR embodied in the stacked CMOS device invention.

Fig. 27 is a physical layout of the circuit shown in Fig. 26.

Fig. 28 is an electrical circuit schematic of a conventional exclusive OR logic function embodied in conventional CMOS devices.

Fig. 29 illustrates an exclusive OR embodied in the stacked CMOS device invention.

Fig. 30 is a physical layout of the circuit shown in Fig. 29.

Fig. 31 is the lowest layer in the composite physical layout of the NAND circuit in Fig. 24, showing the N+ diffusions in the substrate.

Fig. 32 is the second layer in the composite physical layout of the NAND circuit in Fig. 24, showing the gate thin oxide and polycrystalline silicon gate shapes.

Fig. 33 is the third layer in the composite physical layout of the NAND circuit of Fig. 24, showing the laser annealed silicon layer with its P+ regions.

Fig. 34 is the fourth and topmost layer of the composite physical layout of the NAND circuit of Fig. 24, showing the metal interconnection lines.

Fig. 35 is the first and lowest layer in the composite physical layout of the NOR circuit of Fig. 27, showing the substrate with its N+ diffusions.

Fig. 36 is the second layer of the composite physical layout for the NOR circuit in Fig. 27, showing the gate thin oxide and polycrystalline silicon gate shapes.

Fig. 37 is the third layer in the composite physical layout of the NOR logic circuit of Fig. 27, showing the laser annealed silicon layer with its P+ regions.

Fig. 38 is the fourth and topmost layer in the composite physical layout of the NOR circuit of Fig. 27, showing the metal interconnection lines.

Fig. 39 is a composite layout for the flip-flop of Fig. 21.

Fig. 40 is the lowest component layer of Fig. 39, illustrating the substrate diffusions.

Fig. 41 is the gate oxide and polycrystalline silicon layer for Fig. 39.

Fig. 42 is the laser annealed silicon layer for Fig. 39.

Fig. 43 is the top metal interconnection layer for Fig. 39.

Discussion of the Preferred Embodiment

An electrical schematic diagram of the stacked CMOS device structure is shown in Fig. 2 and two alternate cross-sectional views of the device structure are shown in Figs. 3a and 3b where like elements have the same numbering.

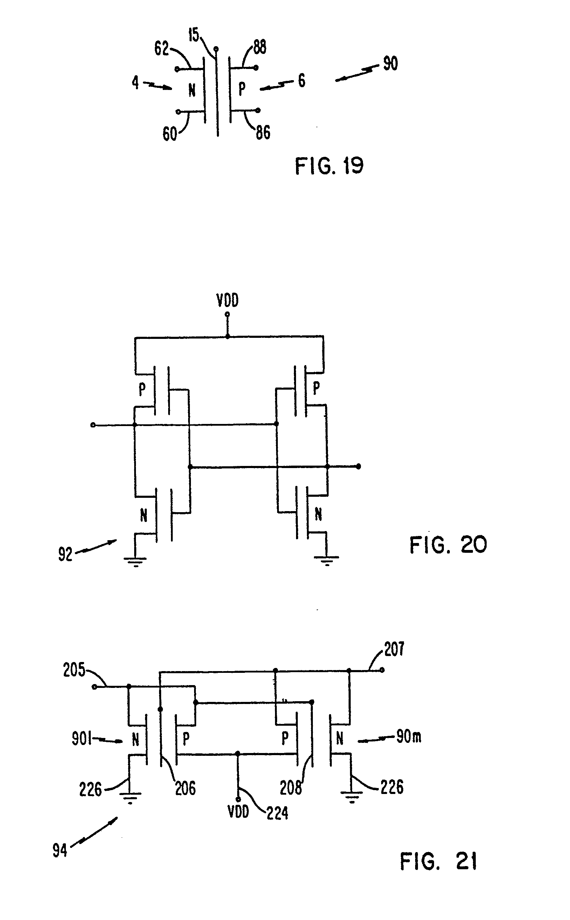

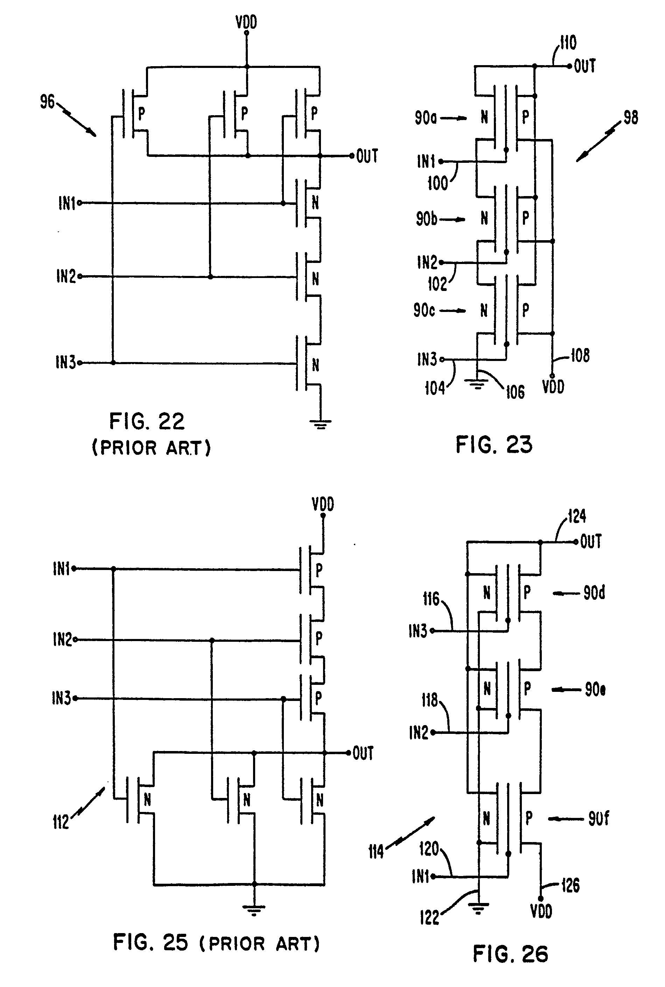

In the embodiment shown in Fig. 3a, the laser annealed silicon (LAS) layer 25 remains contacted at 18 to the N+ diffusion 17 while in the embodiment shown in Fig. 3b, not claimed, the end 18′ has been physically separated from the diffusion 17 by means of an etching step, for example. The structure in Fig. 3a has application in the formation of CMOS inverter circuits such as is schematically shown in Fig. 2. The structure of Fig. 3b has advantage in the formation of logic circuits and other circuits where the source drain paths of consecutive like-channel devices are connected together, such as in the NOR circuit shown in Fig. 26. Fig. 3b shows the more general five terminal device which is schematically represented in Fig. 19, having as the five terminals, the source and the drain of the P channel device, the source and the drain of the N channel device and the gate common to both the N and P channel devices. In such a five terminal device, the substrate contacts can be left with their potentials floating or alternately, can be separately connected to a power supply or in a further alternate arrangement, can be electrically shorted to the corresponding source electrode via the contact from the aluminum layer to the source. This will become clearer as the description of the invention unfolds.

A silicon semiconductor substrate 19 of P-type conductivity is connected by means of the terminal 11 to a negative substrate voltage Vsub. An N+ type source diffusion 16 is connected by means of the terminal 3 to ground potential or to another device terminal and an N+ type drain diffusion 17 is connected by means of the terminal 5 to the output of the circuit. The region 27 between the source 16 and drain 17 forms the channel 27 of the N channel FET device. A layer of silicon dioxide 22 is formed over the surface of the substrate 19 and a layer 15 of polycrystalline silicon is deposited to form the gate electrode for the N channel FET device 4. A second silicon dioxide layer 24 is formed over the polycrystalline silicon gate 15 and then a second layer of polycrystalline silicon generally shown as 25 is deposited on top of the layer 24 so that a first end 18 thereof physically and electrically contacts the drain diffusion 17 of the N channel FET device 4. By means of process steps which will be described later, the polycrystalline silicon layer 25 is converted to a monocrystalline silicon layer, the end 18 thereof is doped P+, the region 20 located above the polycrystalline silicon gate electrode 15 is doped N-, and the region 14 remote from the end 18 and adjacent to the central portion 20 is doped P+. The regions 14 and 13 in the silicon layer 25 serve as the source and drain, respectively of a P channel FET device 6 whose channel region is formed by the intermediate N- doped region 20. Conduction from the source 14 to the drain 13 is achieved by a relatively negative potential between the gate electrode 15 and the source 14 of the P channel FET device 6. The device is completed by the deposition of an upper layer of silicon dioxide 26 which insulates the laser annealed silicon layer from the aluminum layer and forms, in conjunction with the recessed oxide, the field oxide for the device.

The N channel transistor 4 is a conventional silicon gate N channel structure. However the P channel transistor 6 is fabricated upside down from the conventional manner, above the same polycrystalline silicon gate 15. The power for the P channel device 6 is usually applied via an aluminum line contacted to the source 14 of the P channel device and is shown as the drain voltage VDD or as coming from another device. As in conventional complementary MOS circuits wherein the P channel and N channel FET devices have their gates connected to the same input, either one or the other of the two FET devices 4 or 6 is on, depending upon the relative polarity of the input gate voltage at 15. The stacked CMOS device 1 can be considered a five terminal device having a schematic diagram as indicated in Fig. 19. The sandwiched structure can be integrated to a conventional N channel process. Circuit layouts of the structure for typical logic functions demonstrate densities which exceed conventional N channel logic and have a far superior power-delay product.

Several processes will be disclosed which are directed to obtaining good FET device characteristics for the upper P channel transistor. These improved characteristics include a low leakage current, proper threshold voltage, and a self-alignment with the common sandwiched gate electrode as is the case for the lower N channel transistor. The process should produce a structure which provides efficient wiring routing to enable compact placement of the wiring and devices in a large scale integrated circuit chip.

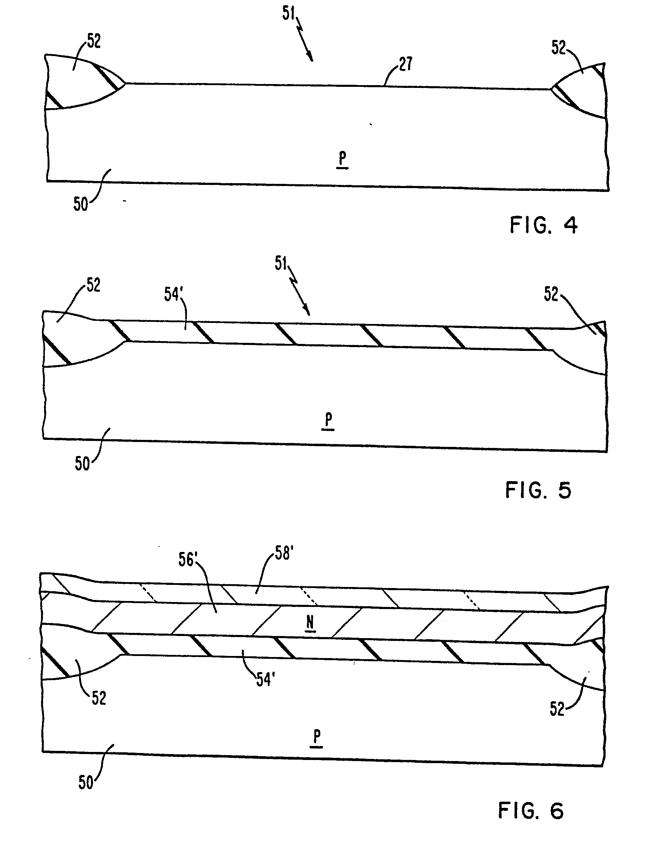

The process steps shown for forming the stacked CMOS device are illustrated in the sequence of figures from Fig. 4 through Fig. 17. Fig. 4 illustrates a starting step wherein the monocrystalline silicon p-type substrate 50 which has a starting resistivity of approximately 10 ohm centimeters, has formed in its surface the recessed oxide isolation regions 52, in a manner well known to the prior art. This defines an isolation area 51 in which the stacked CMOS device will be formed. In addition, the channel 27 has been ion implanted with boron ions to obtain the correct threshold in a manner well known to the prior art.

Fig. 5 illustrates the next step of growing the gate oxide layer 54′ which is a silicon dioxide layer of between 25 and 100 nanometers thickness which can be thermally grown on the surface of the silicon semiconductor substrate 50 within the isolation area 51. At this point, contact holes can be etched through the silicon dioxide layer 54′ in order to enable electrical contact to buried regions. This is to allow subsequent direct contacting of the N+ polycrystalline silicon gate to the drain of the N channel device.

The next significant step is shown in Fig. 6 wherein an N-type doped polycrystalline silicon layer 56′, having been doped for example with phosphorous, to a concentration of greater than $10^{19}$ atoms per cubic centimeter, is deposited to a thickness of from 400 to 1000 nanometers on the surface of the silicon dioxide gate layer 54'. A method of obtaining the P channel gate insulator would be to laser anneal the N+ polycrystalline silicon layer to smooth its upper surface. This would then be followed by the forming of a silicon dioxide layer of 10 to 50 nanometers. This is followed by the deposition of a 25-100 nanometers thick layer of phosphosilicate glass having a phosphorous concentration of approximately 2-4 mole percent which, in its etched form, will eventually provide the self-alignment of the upper transistor P channel gate, as will be subsequently described. The composite silicon dioxide/phosphosilicate glass is shown as 58'.

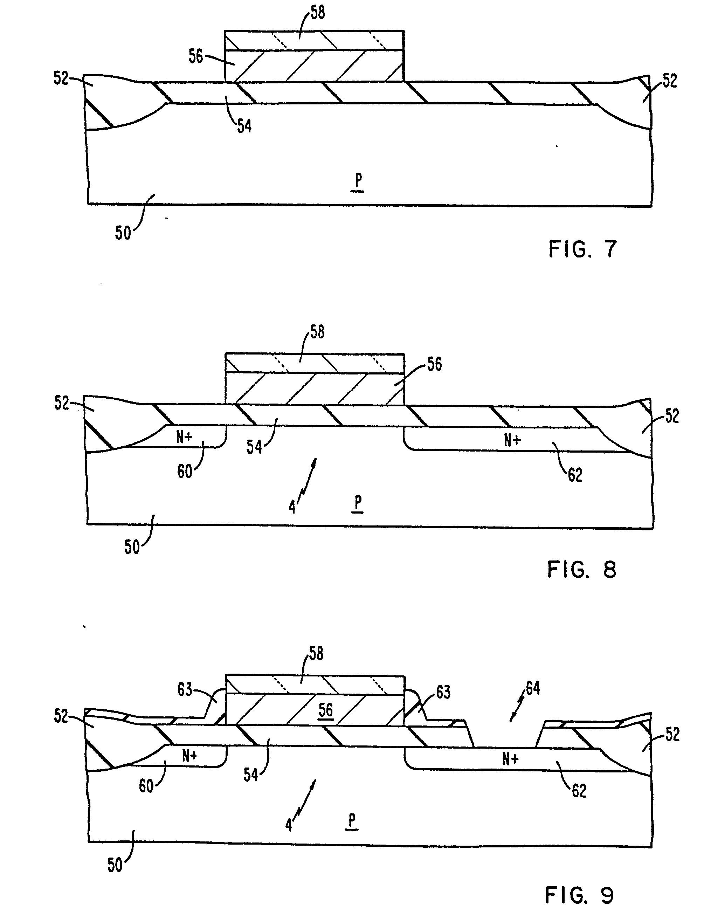

The next significant step is shown in Fig. 7 wherein the composite layer 58' and the polycrystalline silicon layer 56' are etched by means of a reactive ion etching technique or other suitable method, in order to form the polycrystalline silicon gate electrode 56 and the etched composite layer 58, as is shown in Fig. 7.

The next significant step is illustrated in Fig. 8 wherein the source region 60 and drain region 62 are ion implanted into the P-type silicon substrate 50 through the gate oxide layer 54 and are self-aligned by means of the masking effect of the gate 56 and phosphosilicate glass layer 58. The ion implantation species is arsenic which is implanted to a high dosage in a manner well known in the prior art to provide an N+ conductivity for the N channel source and drains of the lower FET device 4. Arsenic is selected as the dopant species for its relatively low thermal diffusivity so that subsequent heat treatment steps on the assembly will not substantially rediffuse the dopant.

The next significant step is illustrated in Fig. 9 wherein an edge oxide 63 is formed on the polycrystalline silicon surface of gate 56 through low temperature steam oxidation or other techniques to a thickness of 20-300 nanometers in order to completely encapsulate the gate electrode 56. This is followed by etching the contact hole 64 through the total oxide layer above the N+ diffusion exposing a portion of the N+ drain 62.

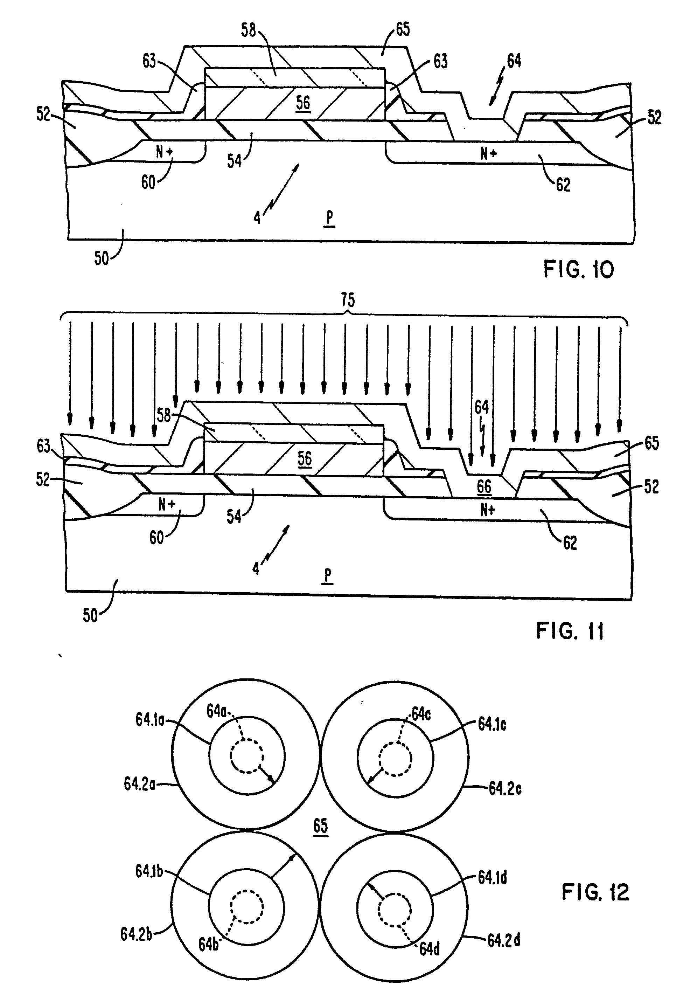

The next significant step is illustrated in Fig. 10 wherein a second layer of polycrystalline silicon 65 is deposited by chemical vapor deposition over the phosphosilicate glass layer 58 above the gate 56 and into the contact hole 64, as shown. The second polycrystalline silicon layer 65 is in situ doped P-type to a concentration of $10^{17}$-$10^{18}$ atoms/cm$^3$ and is deposited to a thickness of from 400 to 1000 nanometers. The layer 65 will ultimately form a portion of the source, channel and drain for the upper, P channel FET device which will share the common gate 56 with the lower N channel FET device 4.

The next significant step is illustrated in Figs. 11 and 12 wherein a laser beam 75 is rendered incident upon the polycrystalline silicon layer 65, including the region 66 of the layer 65 in the contact hole 64, immediately above the drain region 62, as shown. The heat produced in the region 66 of the layer 65 by the laser beam 75 momentarily melts the polycrystalline silicon material. If a pulsed laser is used, approximately 10 joules per square centimeter of energy pulsed from a Nd: YAG laser for a pulse duration of approximately 125 nanoseconds. If a continuous wave laser is used, an approximately 15 watt continuous argon laser can be employed with a scan rate of approximately 10 centimeters per second. As is shown in Fig. 11, the polycrystalline silicon layer 65 lies in a continuous film on the surface of the structure and the laser beam 75 exposes the entire surface of the polycrystalline silicon layer 65. The heat generated from the laser beam melts the polycrystalline silicon material and an epitaxial recrystallization with a crystalline orientation of the substrate's lattice starts in the portion 66 of the layer 65 which contacts the substrate 50 through the hole 64. As is seen in Fig. 12, there is a progressive lateral growth of the monocrystalline state for the material of layer 65 as the layer is continuously exposed to the heat from the laser beam. As may be seen in Fig. 12, the hole 64 is shown for four adjacent devices as the holes 64a, 64b, 64c and 64d. These holes are shown hidden behind the polycrystalline layer 65. After a first duration of exposure to the laser beam energy, the region of monocrystalline reorientation of the layer 65 is encompassed by the particular boundaries 64.1a which surrounds 64a, 64.1b which surrounds 64b, 64.1c, which surrounds 64c and 64.1d which surrounds 64d. After a still longer duration of exposure of the layer 65 to the energy from the laser beam, a still larger region of monocrystalline reorientation of the layer 65 is encompassed by the respective circular areas 64.2a, 64.2b, 64.2c and 64.2d. Eventually, the regions of monocrystalline reorientation in the originally polycrystalline silicon layer will have grown out from the original hole 64 to completely overlap and form a continuous monocrystalline silicon layer 65 having a lattice orientation epitaxially formed as the same orientation of the monocrystalline silicon substrate 50.

This technique is not unlike the seed crystal, lattice reorientation principle associated with zone melting and refinement of larger silicon boles, well known in the art. The object of laser annealing is to reorient the entire layer 65 from a polycrystalline phase to a monocrystalline phase in order to provide a high mobility medium for the formation of the upper, P channel FET device. Laser induced epitaxy of amorphous silicon layers has been described in the literature, for example J. C. Bean, et al., "Substrate and Doping Effects Upon Laser Induced Epitaxy of Amorphous Silicon," Journal of Applied Physics, 50(2), February 1979, pp. 881-885. This publication describes a laser heating technique for converting an amorphous silicon film material into a monocrystalline material by epitaxial reorientation from a monocrystalline surface as a seed material.

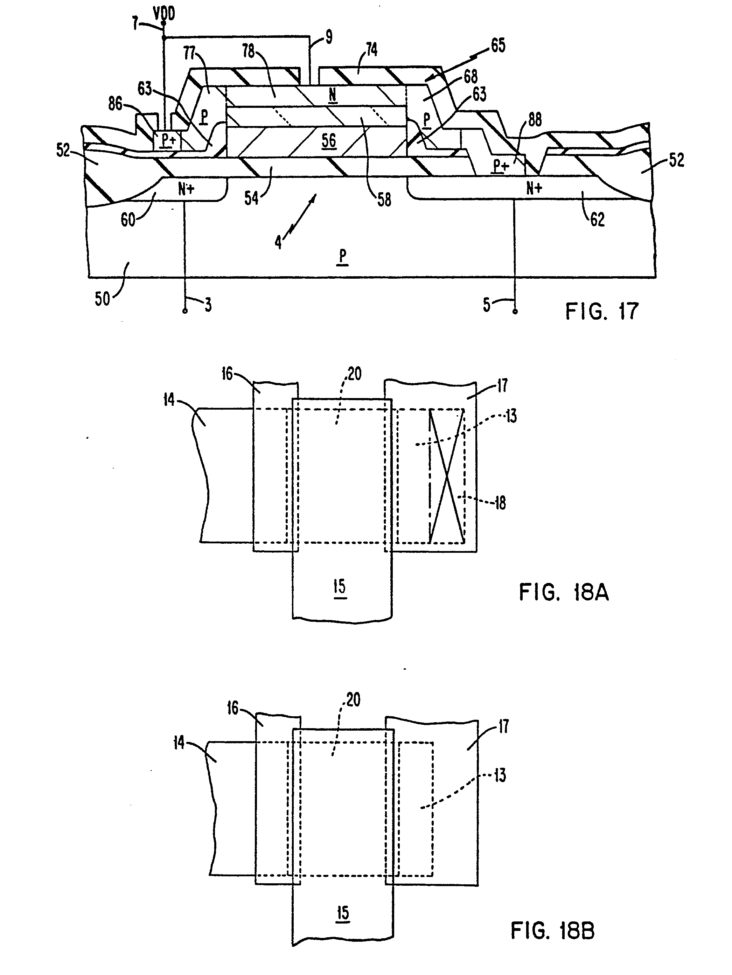

The continuous polycrystalline silicon layer, which has now been laser recrystallized, is etched to form the delineated segment 13 in Fig. 18 covering the source 60, gate 56, and drain 62 of the lower FET device 4 shown in Fig. 10.

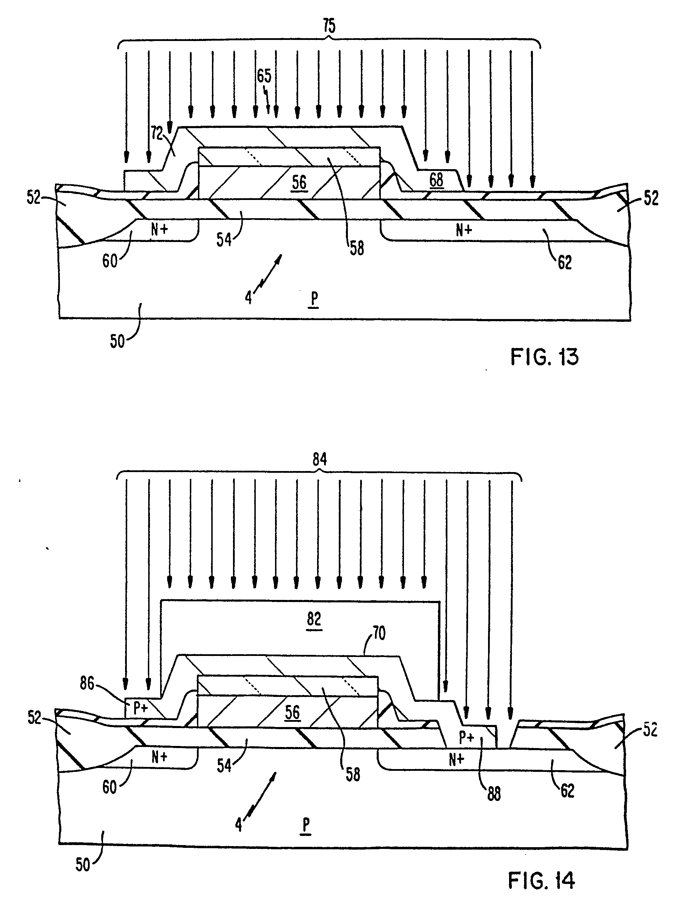

In an alternate embodiment of the invention, the scanned laser beam 75' shown in Fig. 13 can initially expose an arbitrary portion of the etched polycrystalline silicon layer 65 to enlarge the grain of silicon exposed at the point of incidence, thus reversing the sequence of laser annealing and etching discussed in the first embodiment. It has been reported in A. Gat, et al. "CW Laser Anneal of Polycrystalline Silicon: Crystalline Structure, Electrical Properties," Applied Physics Letters, 33(8), October 1978, that the granular sides of polycrystalline silicon can be significantly enlarged by laser annealing without the need for an initial seed from a large monocrystalline silicon surface. The resultant orientation of the recrystallized silicon material will be arbitrary and have the orientation of the original monocrystalline grain.

As an option, if a high conductivity P+ region is desired, the P-type ion implantation 84 in Fig. 14 is to be carried out to define the high concentration P-type source and drain regions 86 and 88, respectively of the upper, P channel FET device 6. In order to perform this ion implantation exclusively for the source and drain regions 86 and 88 of the P channel FET device, a block out mask 82 is placed over the central region of the assembly including the gate 56 in order to avoid inadvertently ion implanting a P-type conductivity in the central regions. A block out mask can be made of for example a photoresist material which is thick enough to stop the boron ions from penetrating into the structures already formed.

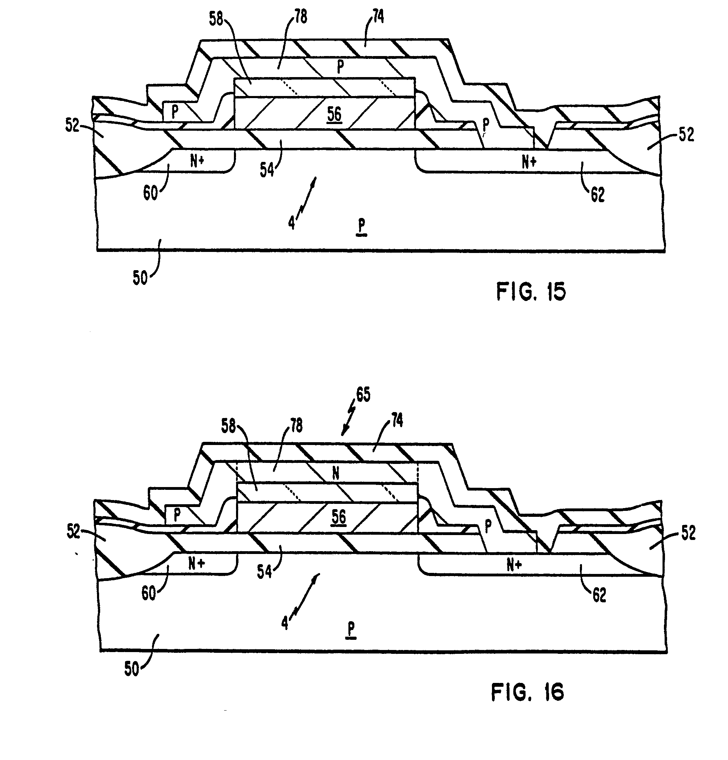

The next significant step following a laser recrystallization step, is shown in Fig. 15 wherein a silicon dioxide layer 74 is deposited by chemical vapor deposition to a thickness of approximately 300 nanometers.

The next significant step is illustrated in Fig. 16 wherein the assembly is heat treated to perform a solid state diffusion of phosphorous from the phosphosilicate glass (PSG) material in the layer 58 into the monocrystalline silicon layer 65, as is shown in the figure. During the heating step, phosphorous atoms are diffused out of the phosphosilicate glass layer 58 in an upward direction and dope the silicon layer 65 to an N-type conductivity in the region 78 of the layer 65, as is shown. In Fig. 15, the region 78 will form the active channel region of the upper, P channel FET device 6. It is to be noted that the phosphosilicate glass layer 58 was etched and delineated at the same time as was the polycrystalline silicon gate region 56, and thus the region 78 of N-type conductivity produced by the solid state diffusion of the phosphorous atoms from the PSG layer 58, will be self-aligned with the polycrystalline silicon gate 56. In this manner, the channel of the upper, P channel FET device 6 will be self-aligned with the gate 56 which is shared in common with the self-aligned N channel FET device 4.

The resultant P channel FET device has less overlap capacitance of the gate to the drain, better control of the width to length ratio for higher power and performance distribution, a smaller area required for the layout of the device, and it may have direct contact between the N+ diffusion and the P-type laser annealed silicon.

The relative thicknesses of the PSG layer 58 and the silicon layer 65, the phosphorous doping concentration of the PSG layer 58 and the energy density and exposure duration of the laser beam 75 in the step of Fig. 11 can be adjusted so that the solid state diffusion of phosphorous atoms from the PSG layer 58 into the silicon layer 65 may be completed during the step of recrystallization of the polycrystalline phase of silicon layer 65 into its monocrystalline phase.

The next step in Fig. 17 is carried out to etch contact holes through CVD oxide layer 74 so as to enable the electrical contact of the source 86 and the "substrate" 78 of the P channel FET device. Any other suitable contacts which are to be made can be formed at this time. An aluminum wiring pattern is then deposited to interconnect the device shown in Fig. 17 with other devices in a large scale integrated circuit chip. The p+ source 86 and p+ drain 88 are optional as discussed previously.

Figs. 18a and 18b illustrate top views of the resulting stacked CMOS device shown in Figs. 3a and 3b, respectively more plainly illustrating the delineation of the upper silicon layer 65. Figs. 3a, 3b, 18a, 18b and Figs. 4 through 17 can be equated as follows. In Fig. 3a, diffusions 16 and 17 correspond to diffusions 60 and 62 in Fig. 17. In Fig. 3a, the thin oxide layer 22 corresponds to the thin oxide layer 54 in Fig. 17. In Fig. 3a, the upper insulating oxide 24 corresponds to the oxide regions 58 and 63 of Fig. 9. The gate electrode 15 of Fig. 3a corresponds to the gate electrode 56 of Fig. 17. The layer of laser annealed silicon 25 in Fig. 3a corresponds to the layer of laser annealed silicon 65 of Fig. 17. New portions 14, 20, 13 and 18 of the laser annealed silicon layer 25 of Fig. 3a correspond to the portions 86, 77, 78, 68 and 88 of the layer 65 of laser annealed silicon in Fig. 17.

The stacked CMOS device can be considered as a five terminal device 90 which is shown in electrical schematic · diagram form in Fig. 19 wherein the contacts to the source 60 and drain 62 contacts for the N channel FET device 4, the contacts to the source 86 and drain 88 regions for the P channel FET device 6 and the gate electrode 56 for the two FET devices can be considered the five terminals of device 90.

This five terminal device concept enables the layout of conventional CMOS circuits in a more highly compact form than has been available in the prior art. For example, in Fig. 20, a conventional CMOS circuit topology 92 is shown for a flip-flop function, consisting of a pair of crosscoupled CMOS inverters 2 as shown in Fig. 1. Fig. 21 illustrates the circuit implementation 94 of the flipflop function employing the stacked CMOS device invention, using two of the five terminal devices 90 shown in Fig. 19. It is to be noted that the cross-sectional area occupied by the resulting circuit 94 is less than half that which would be occupied in the conventional CMOS embodiment 92.

Still other illustrations of the amenability of the stacked CMOS device 90 to compact layout of conventional logic functions is shown in Figs. 22 through 30. Fig. 22 illustrates a circuit schematic diagram of a conventional, six device CMOS circuit 96 for a three input NAND logic function and Fig. 23 illustrates the circuit 98 for the same logical function as it would be embodied in a stacked CMOS device invention, using three of the five terminal devices 90 of Fig. 19. Fig. 24 shows the top view of an integrated circuit layout for the circuit shown in Fig. 23. Devices 90a, 90b and 90c have input gates 100, l02 and 104, respectively. The common source 154 of P channel devices 90aP and 90bP is connected to the positive potential 108 through, the P+ to A1 contact 101a. The source 158 of P channel device 90cP is connected to line 108 through the contact 101b. Drains 168 and 156 of the P channel devices 90bP, 90cP and 90aP are shorted together at the metal level 101c. The common drain of the P channel devices is shorted to the drain of the N channel device 90aN through the P+ to N+ contact 101d. Ground potential 106 is connected only to the source 158 of N channel device 90cN through the N+ to metal contact 101e. Power buses common to many circuits are at the metal level. It can be seen that the three input NAND logic functions can be embodied as the circuit 98 in a very small space on a large scale integrated circuit chip.

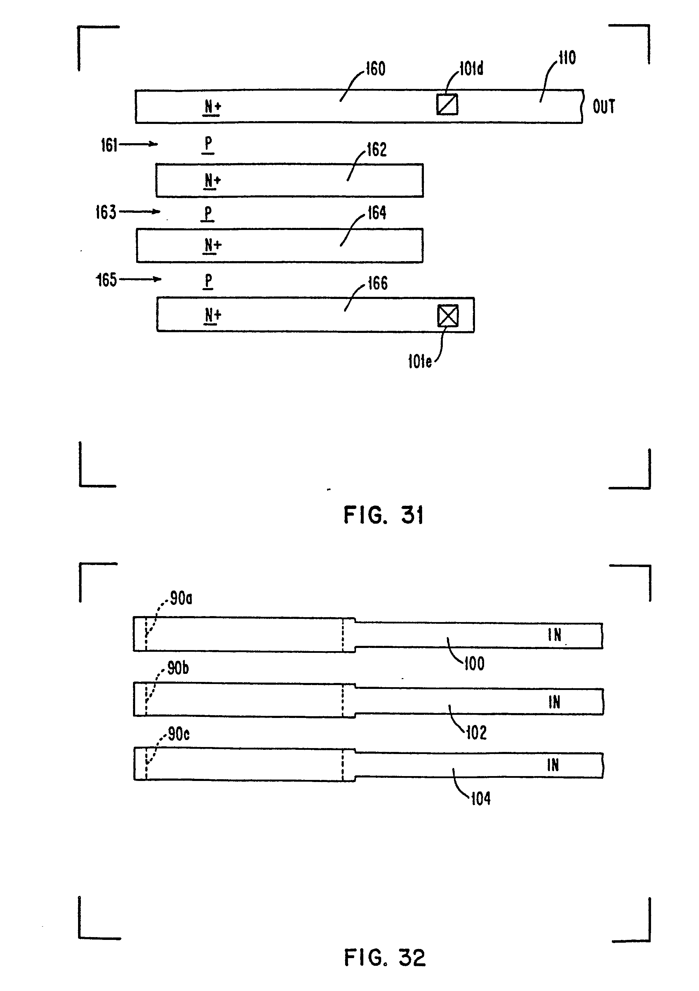

The stacked CMOS, three-input NAND integrated circuit layout shown in Figure 24 is decomposed into four levels, the first or lowest layer shown in Figure 31 is of the N+ diffusions in the substrate, the second layer shown in Figure 32 is of the gate thin oxide and polycrystalline silicon gate shapes, the third layer illustrates the P+ regions in the laser annealed silicon layer, and the fourth or topmost layer illustrates the metal interconnection lines.

A first diffusion bar 160 of Figure 31 which corresponds to the diffusion 17 in Figure 3b, is of N-type conductivity in the P-type silicon substrate which corresponds to 19 of Figure 3b. A second diffusion bar 162 of Figure 31 which corresponds to the diffusion 16 of Figure 3b, is of N-type conductivity in the substrate and is located in spaced, parallel relationship with the first bar 160 so that it forms a first N channel region 161 therebetween, which corresponds with region 27 shown in Figure 3b.

A third diffusion bar 164 of Figure 31 is of N-type conductivity in the substrate and is located in spaced, parallel relationship with the second bar 162, forming a second N channel region 163 therebetween. A fourth diffusion bar 166 in Figure 31 is of N-type conductivity in the substrate and is located in spaced, parallel relationship with the third bar 164, forming a third N channel region 165 therebetween.

The first N channel region 161 is covered by an insulating layer 22 as is shown in Figure 3b, which supports a first logical input gate electrode 100 in Figure 32 which corresponds to the electrode 15 in Figure 3b, which is juxtaposed with the first N channel region 161, forming a first N channel FET device 90aN, as shown in Figure 23.

The second N channel region 163 is covered by an insulating layer 22, which supports a second logical input gate electrode 102 shown in Figure 32, which is juxtaposed with the second N channel region 163, forming a second N channel FET device 90bN as is shown in Figure 23.

The third N channel region 165 is covered by an insulating layer 22 which supports a third logical gate electrode 104 as shown in Figure 32, which is juxtaposed with the third N channel region 165, forming a third N channel FET device 90cN.

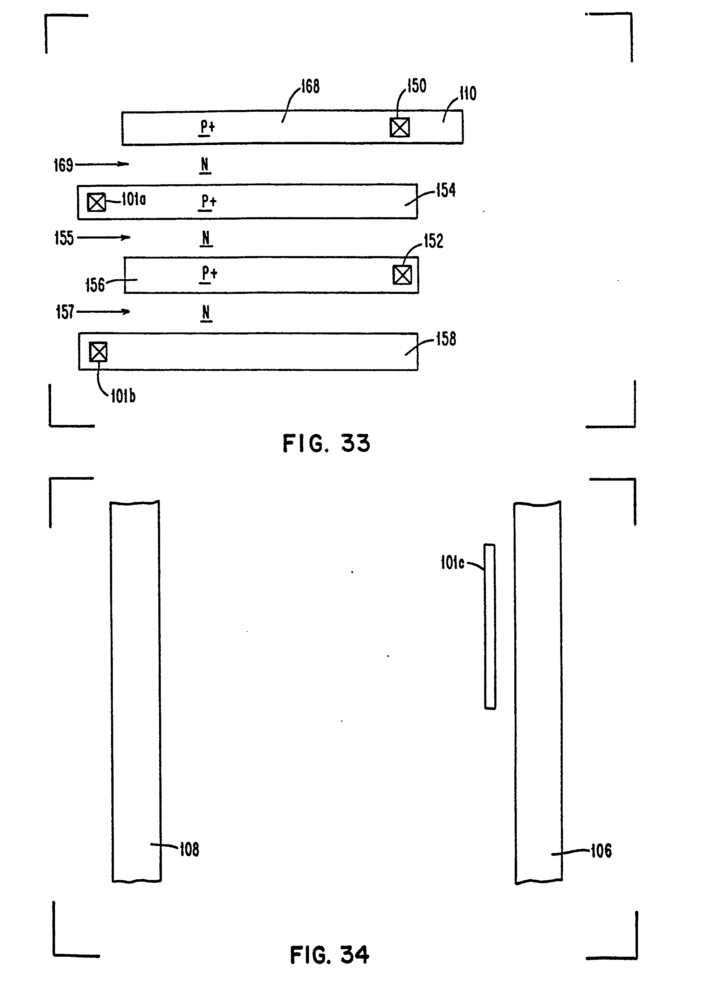

A layer of laser annealed silicon 25 of Figure 3b has a first N-type portion 169 of Figure 33 or portion 20 covers a juxtaposed portion of the first gate electrode 100, and which further has a first P-type portion 168 in Figure 33 which corresponds to the portion 13 in Figure 3b, which is juxtaposed over the first diffusion bar 160, and the layer further has a second P-type portion 154 shown in Figure 33 corresponding to the portion 14 in Figure 3b, which is juxtaposed over the second diffusion bar 162, thereby forming a first P channel FET device 90aP as is shown in Figure 23.

The layer of laser annealed silicon 25 has a second N-type portion 155 covering the juxtaposed portion of the second gate electrode 102 and the layer has a third P-type portion 156 in Figure 33 which is juxtaposed over the third diffusion bar 164 forming a second P channel FET device 90bP of Figure 23, with the second P-type portion 154.

The layer of laser annealed silicon 25 has a third N-type portion 157 covering the juxtaposed portion of the third gate electrode 104 and the layer further has a fourth P-type portion 158 of Figure 33, which is juxtaposed over the fourth diffusion bar 166, forming a third P channel FET device 90cP with the third P-type portion 156.

The first N+ diffusion bar 160 is connected to the logical output terminal 110 of Figure 31 labeled OUT. The fourth diffusion bar 166 is connected to the ground metal line 106 in Figure 34 by means of the via contact 101b. The second diffusion bar 162 operates as the source of the first N channel FET 90aN and the drain of the second N channel FET 90bN. The third diffusion bar 164 operates as the source of the second N channel FET 90bN and as the drain of the third N channel FET 90cN.

The first P+ portion 168 and the third P+ portion 156 of the layer of laser annealed silicon 25 are connected to the logical output terminal 110 and the second P+ portion 154 and the fourth P+ portion 158 are connected to the positive metal line 108 by means of the respective contacts 101a and 101b. The second portion 154 operates as the source for both the first P channel FET 90aP and the second P channel FET 90bp, The third P+ portion 156 operates as the drain for both the second P channel FET 90bP and the third P channel FET 90cP.

The resulting stacked CMOS, three-input NAND integrated circuit occupies less space than does the conventional CMOS NAND circuit shown in Figure 22. In fact, the area is no larger than that for a conventional NMOS three input NAND circuit.

It should be noted that the doped, recrystallized silicon layer forming line 168 can also form device interconnection wiring in Figure 24, thus adding an additional degree of freedom for wirability which features gate cross-overs.

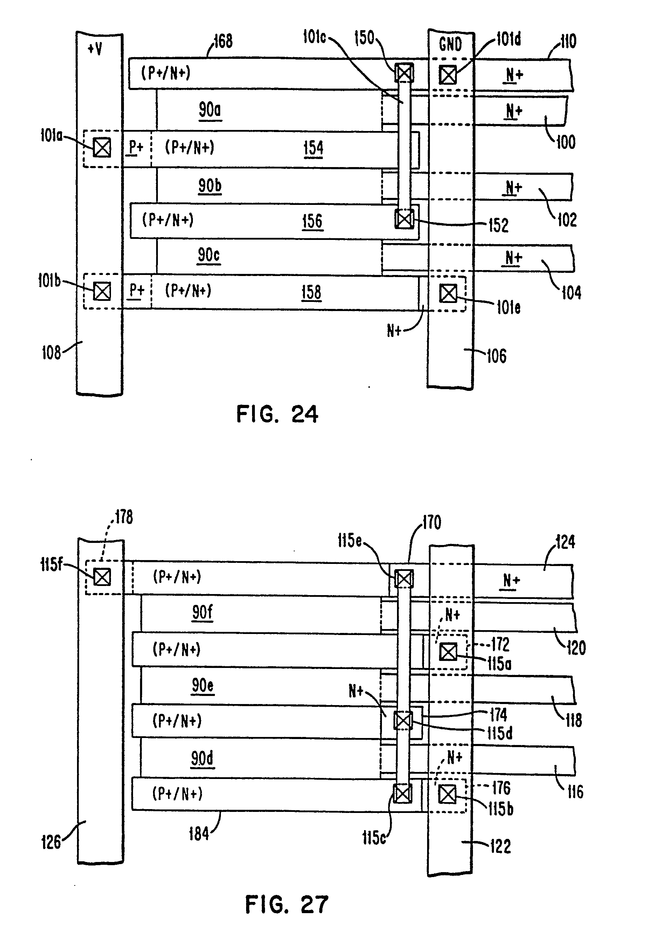

Figure 25 illustrates a conventional CMOS circuit 112 for a NOR logic function embodied in conventional CMOS devices and Figure 26 illustrates the same NOR function embodied in the circuit 114 using the stacked CMOS devices 90. Figure 27 illustrates an actual layout of the circuit. Devices 90d, 90e, and 90f have input gates 116, 118 and 120, respectively. Sources 172 and 176 of the N channel devices are connected to ground potential 122 through the N+ to metal contacts 115a and 115b. The drains 170 and 174 of the N channel devices are connected in common to the drain 184 of P channel device 90dP through the P+ to Al contact 115c, 115d and 115e. The common node, drain 184 of the P channel device 90dP and the drains 170 and 174 of N channel devices 90dN, 90eN, 90fN, become the output 124. The positive potential 126 is connected only to the drain 178 of P channel device 90fP through P+ to metal contact 115f.

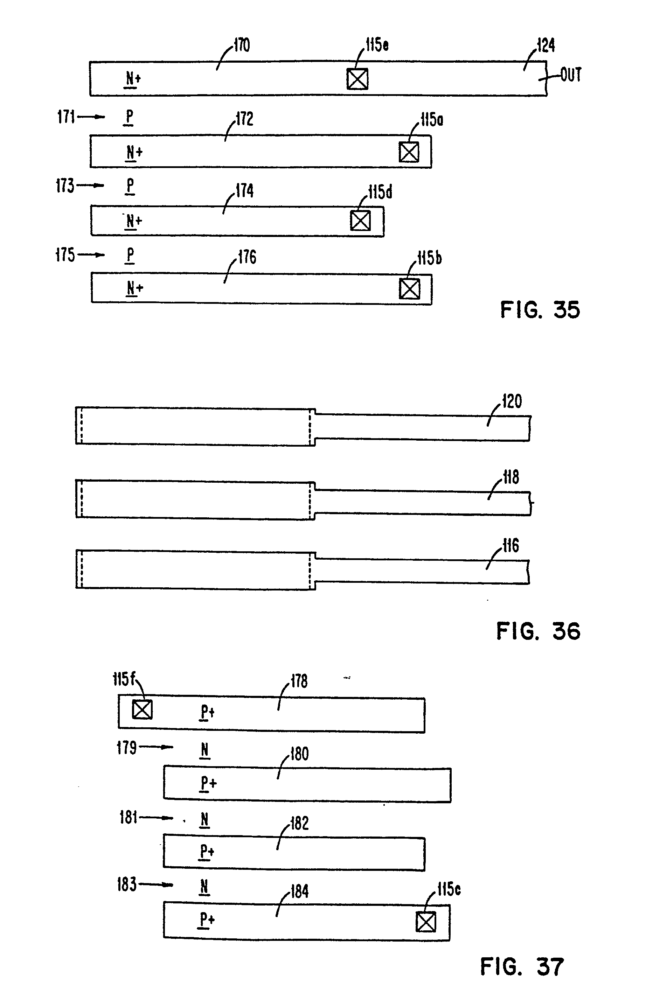

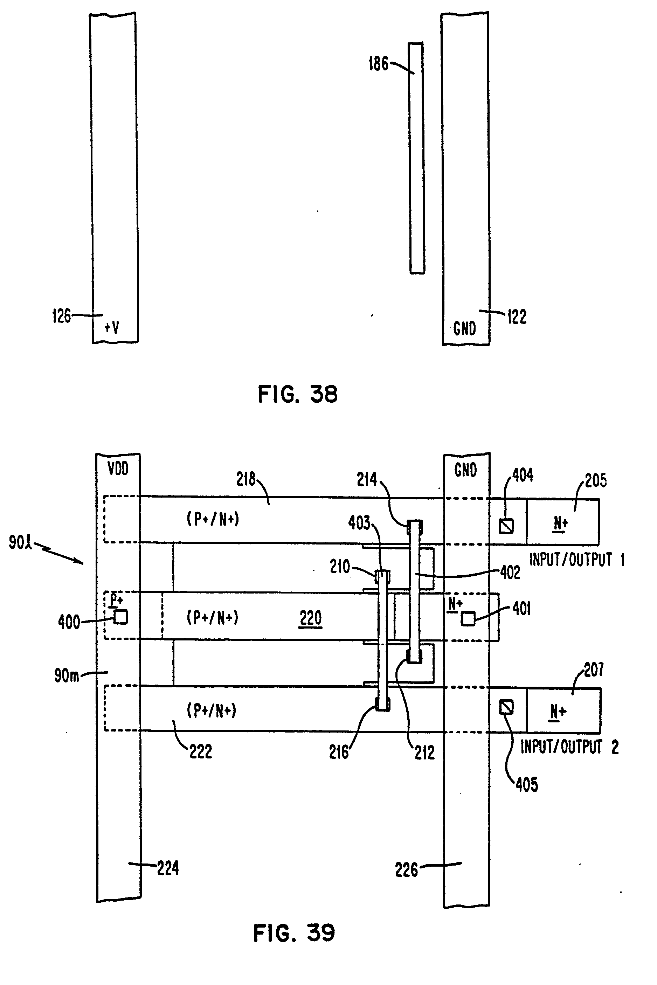

Figures 35 through 38 show four component levels of the composite layout for the NOR circuit shown in Figure 27. Figure 35 illustrates the first or lowest layer which are the N+ diffusions in the substrate. Figure 36 illustrates the second layer which shows the shapes of the gate thin oxide and the polycrystalline silicon gates for the NOR. Figure 37 shows the third layer which is the laser annealed silicon layer which contains the P+ regions. Figure 38 illustrates the fourth and topmost layer which contains the metal interconnection lines.

The stacked CMOS, three-input NOR integrated circuit includes the first diffusion bar 170 of Figure 35 which corresponds to the diffusion 17 of Figure 3b, of N-type conductivity in the P-type silicon substrate 19 of Figure 3b. A second diffusion bar 172 of Figure 35 corresponds to the diffusion 16 of Figure 3b and is of N-type conductivity in the substrate, and is located in spaced, parallel relationship with the first diffusion bar 170, thereby forming a first N channel region 171 therebetween, which corresponds to the region 27 of Figure 3b.

A third diffusion bar 174 of Figure 35 is of N-type conductivity in the substrate and is located in spaced, parallel relationship with the second diffusion bar 172, thereby forming a second N channel region 173 therebetween. A fourth diffusion bar 176 in Figure 35 is of N-type conductivity in the substrate and is located in spaced, parallel relationship with the third bar 174, thereby forming a third N channel region 175 therebetween.

A first logical input gate electrode 120 of Figure 36 corresponds to the electrode 15 of Figure 3b, and is juxtaposed over the first N channel region 171 which is covered by an insulating layer 22 of Figure 3b, with the first N channel region 171 forming a first N channel FET device 90fN.

A second logical input gate electrode 118 of Figure 36 is juxtaposed over the second N channel region 173 which is covered by an insulating layer 22, with the second N channel region 173 forming a second N channel FET device 90eN.

A third logical input gate electrode 116 of Figure 36 is juxtaposed over the third N channel region 175 which is covered by an insulating layer 22, with the third N channel region 175 forming a third N channel FET device 90dN.

A layer of laser annealed silicon 25 of Figure 3b has a first N-type portion 179 of Figure 37 which corresponds to portion 20 of Figure 3b, covering the juxtaposed portion of the first gate electrode 120, and the layer further has a first P-type portion 178 of Figure 37 which corresponds to the portion 14 of Figure 3b, juxtaposed over the first diffusion bar 170, and the layer further has a second P-type portion 180 of Figure 37 which corresponds to the portion 13 of Figure 3b, which is juxtaposed over the second diffusion bar 172, thereby forming a first P channel FET device 90fP.

The layer of laser annealed silicon 25 has a second N-type portion 181 of Figure 35 which covers the juxtaposed portion of the second gate electrode 118 and has a third P-type portion 182 which is juxtaposed over the third diffusion bar 174 forming a second P channel FET device 90eP with the second P-type portion 180.

The layer of laser annealed silicon 25 has a third N-type portion 183 of Figure 37 which covers the juxtaposed portion of the third gate electrode 116 and it has a fourth P-type portion 184 which is juxtaposed over the fourth diffusion bar 176, thereby forming a third P channel FET device 90dP with the third P-type portion 182.

The first diffusion bar 170 is connected to a logical output terminal 124. The fourth diffusion bar 176 is connected by means of contact 115b of Figure 35 to the ground metal line 122 of Figure 38. The second diffusion bar 172 is connected to the ground metal line 122, and operates as the source of the first N channel FET device 90fN and as the source of the second N channel FET device 90eN. The third diffusion bar 174 is connected to the output terminal 124 by means of the contact 115d, the metal line 186, and contact 115e and it operates as the drain of the second N channel FET device 90eN and as the drain of the third N channel FET device 90dN.

The fourth P-type portion 184 of the laser annealed silicon layer 25 is connected by means of the contact 115c, the metal line 186, and the contact 115e to the logical output 124. The first P-type portion 178 is connected by means of the contact 115f to the positive potential metal line 126, and operates as the source for the first P channel FET device 90fP. The second P-type portion 180 operates as the drain for the first P channel FET device 90fP and as the source for the second P channel FET device 90eP. The third P-type portion 182 operates as the drain for the second P channel FET device 90eP and the source for the third P channel FET device 90dP. The fourth P-type portion 184 of the silicon layer 25 operates as the drain of the third P channel FET device 90dP.

It can be seen in Figure 27 that the area occupied by the three input NOR logic function 114 is substantially reduced over that which would be required in the prior art due to isolation needed between N channel and P channel devices.

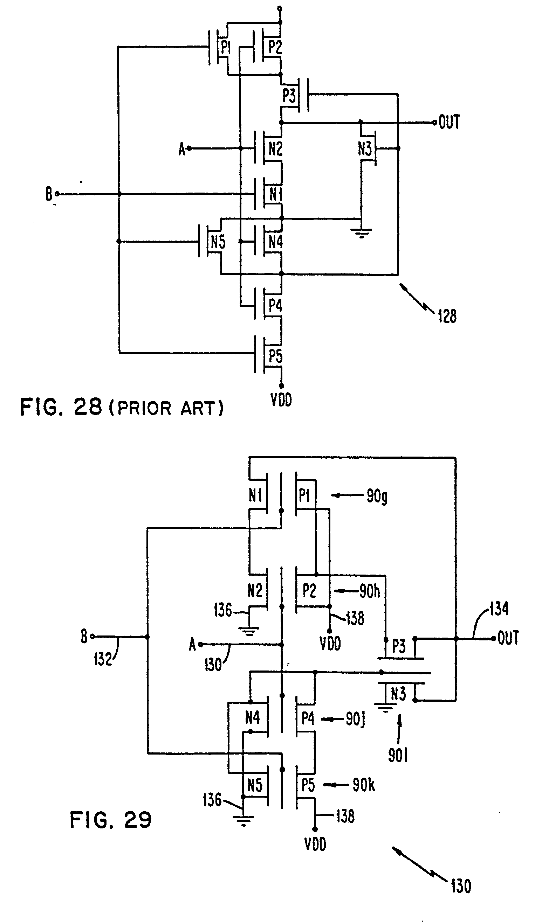

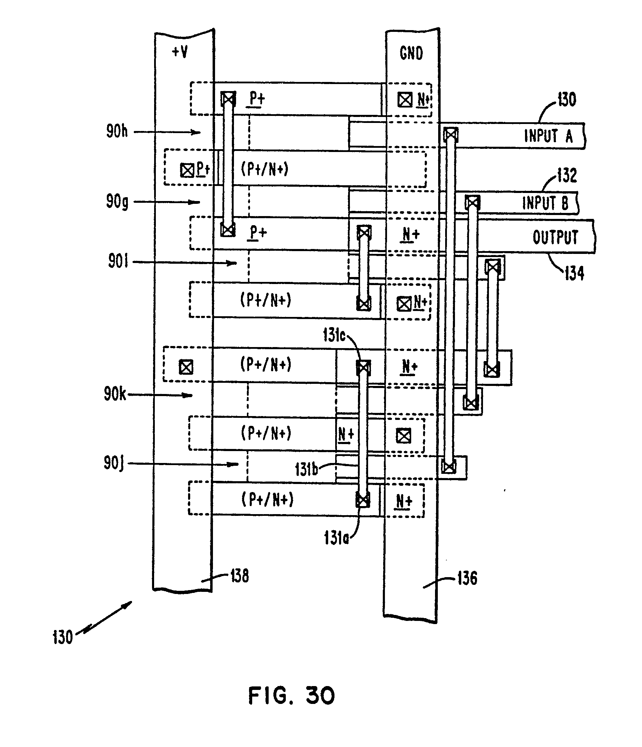

Figure 28 illustrates a conventional electrical circuit schematic diagram for an exclusive OR function embodied in conventional CMOS device circuit 128. Figure 29 illustrates the same exclusive OR circuit as it would be embodied in the circuit 130 employing the stacked CMOS device 90. Figure 30 is a top view of the actual layout of the circuit 130 shown in Figure 29. The P+ or N+ electrode can also be used for device to device interconnections, for example the drains of N channel device 90j and P channel device 90j are connected together through the P+ to N+ contact 131a. This node is connected to the drain of N channel device 90k via P+ electrode 131b and the P+ to N+ contact 131c. Other device to device interconnections are made using N+ or P+ and/or metal electrodes to complete the exclusive OR function as shown in Figure 30.

It is seen from the above that substantial improvements can be made in circuit density by employing the disclosed process to implement the disclosed stacked CMOS device for conventional CMOS circuits.

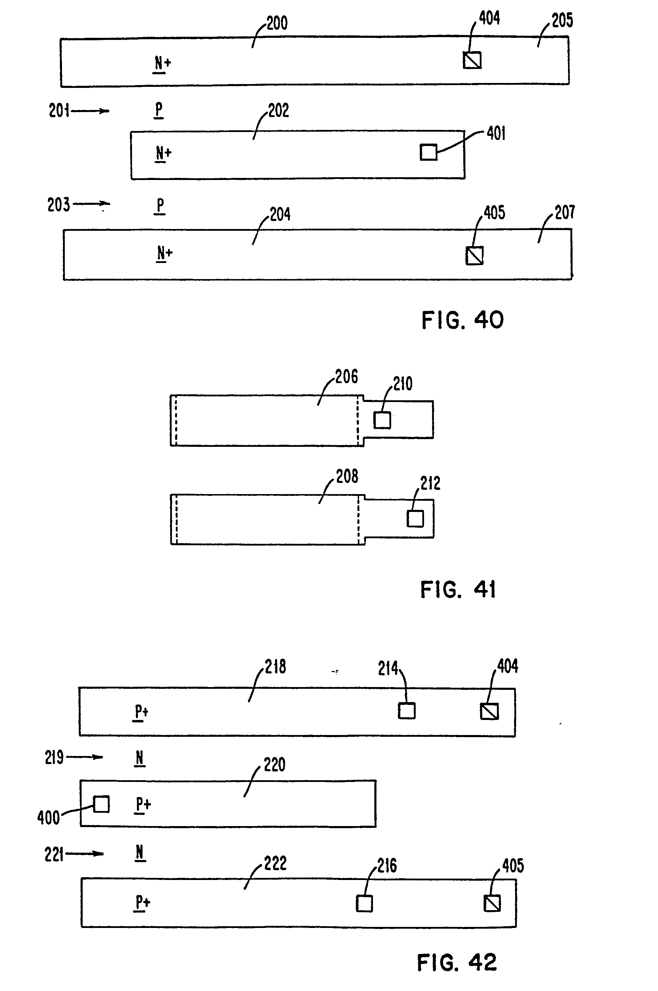

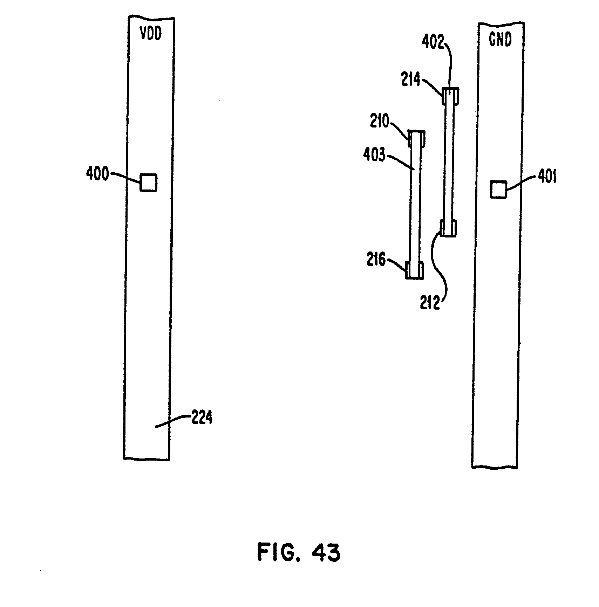

The stacked CMOS flip-flop which is illustrated in the circuit diagram of Figure 21, is shown in a composite layout in Figure 39. Figure 40 illustrates the first lowest layer of the composite of Figure 39, showing the substrate N+ diffusions for the flip-flop circuit. Figure 41 shows the second lowest layer in the composite of Figure 39, showing the gate thin oxide and polycrystalline silicon shapes for the flip-flop circuit. Figure 42 is the third lowest layer of the composite of Figure 39, illustrating the laser annealed silicon layer with the P+ regions for the flip-flop circuit. Figure 43 illustrates the fourth or top component layer of the composite of Figure 39, showing the metal interconnection lines for the flip-flop circuit.

The stacked CMOS flip-flop integrated circuit includes a first diffusion bar 200 in Figure 40 which corresponds to the diffusion 16 in Figure 3b, which is of N-type conductivity in the P-type silicon substrate which corresponds to 19 of Figure 3b. A second diffusion bar 202 in Figure 40, which corresponds to diffusion 17 in Figure 3b, is of N-type conductivity in the substrate and is located in spaced, parallel relationship with the first diffusion bar 200, forming a first N channel region 201 in Figure 40, therebetween, which corresponds to the N channel region 27 in Figure 3b. A third diffusion bar 204 in Figure 40 is of N-type conductivity in the substrate and is located in spaced, parallel relationship with the second diffusion bar 202, forming a second N channel region 203 of Figure 40, therebetween.

A first logical input gate electrode 206 in Figure 41, which corresponds to the gate electrode 15 in Figure 3b, is juxtaposed over the first N channel region 201 which is covered by an insulating layer which corresponds to 22 in Figure 3b, with the first N channel region 201 forming a first N channel FET device 901N.

A second logical input gate electrode 208 of Figure 41, is juxtaposed over the second N channel region 203 which is covered by the insulating 22, with the second N channel region 203 forming a second N channel FET device 90mN.

A layer of laser annealed silicon such as 25 in Figure 3b, has a first N-type portion 219 of Figure 42, which corresponds to the N-type portion 20 of Figure 3b, which covers the juxtaposed portion of the first gate electrode 206, a first P-type portion 218 of Figure 42, which corresponds to the P-type portion 14 of Figure 3b, which is juxtaposed over the first diffusion bar 200, and a second P-type portion 220 of Figure 42, which corresponds to the P-type portion 13 of Figure 3b, which is juxtaposed over the second diffusion bar 202, forming a first P channel FET device 901P.

The silicon layer 25 has a second N-type portion 221 of Figure 42, which covers the juxtaposed portion of the second gate electrode 208 and further has a third P-type portion 222 of Figure 42, which is juxtaposed over the third diffusion bar 204, forming a second P channel FET device 90mP with the second P-type portion 220.

The first diffusion bar 200 is connected to a first logical output terminal 205. The second diffusion bar 202 is connected to ground potential 226 by means of the via contact 401. The third diffusion bar 204 is connected to a second logical output terminal 207. The second diffusion bar 202 operates as the source of the first N channel FET device 901N and the source of the second N channel FET device 90mN.

The second P-type portion 220 is connected to the positive potential metal line 224 by means of the via contact 400, so as to operate as the source for both the first P channel FET device 901P and the second P channel FET device 90mP. The first diffusion bar 200 is connected to the first P-type portion 218 by means of the via contact 404. The third diffusion bar 204 is connected to the third P-type portion 222 by means of the via contact 405.

The first gate electrode 206 is connected to the third P-type portion 222 by means of the via contact 210, the metal line 403, and the via contact 216. The second gate electrode 208 is connected by means of the via contact 212, the metal line 402, and the via contact 214 to the first P-type portion 218.

In this manner, an improved flip-flop circuit having a reduced layout area is obtained.

Although specific embodiments of the invention have been disclosed, it will be understood by those of skill in the art that the foregoing and other changes in form and detail may be made therein without departing from the scope of the invention.

## Claims

1. A stacked CMOS device, the individual complementary FET devices (4, 6) of which share a common gate (15, 56) sandwiched between them, comprising;

a layer of phosphosilicate glass (24, 58) on top of the gate electrode (15, 56) of an N channel field effect transistor device (4) formed in the surface of a monocrystalline silicon substrate (19, 50) having source (16, 60) and drain (17, 62) regions in said substrate on either side of said gate;

a layer of laser annealed silicon (25, 65) over said phosphosilicate glass layer (24, 58), extending over said source and drain diffusions and physically contacting a portion of the surface of said monocrystalline silicon substrate (19, 50) of said N channel device (4);

an N-type region (20, 78) in said silicon layer (25, 65), which is juxtaposed with said gate electrode (15, 56) and is self-aligned to said gate electrode, forming the channel of a P channel device (6), the source (14, 86) and drain (13, 88) regions of which are formed by P-type portions of said silicon layer (25, 65) on either side of said channel.

2. The stacked CMOS device of claim 1 wherein said portion of said substrate is the drain (17, 62) of said N channel FET device (4).

3. The stacked CMOS device according to claims 1 or 2 characterized in that it is used to form a three input NAND integrated circuit, comprising:

a first diffusion bar of N-type conductivity in a P-type silicon substrate;

a second diffusion bar of N-type conductivity in said substrate located in spaced, parallel relationship with said first bar forming a first N channel region therebetween;

a third diffusion bar of N-type conductivity in said substrate located in spaced, parallel relationship with said second bar forming a second N channel region therebetween;

a fourth diffusion bar of N-type conductivity in said substrate located in spaced, parallel relationship with said third bar forming a third N channel region therebetween;

a first logical input gate electrode juxtaposed over said first N channel region which is covered by an insulating layer, with said first N channel region forming a first N channel FET device;

a second logical input gate electrode juxtaposed over said second N channel region which is covered by an insulating layer, with said second N channel region forming a second N channel FET device;

a third logical input gate electrode juxtaposed over said third N channel region which is covered by an insulating layer with said third N channel region forming a third N channel FET device;

a layer of laser annealed silicon having a first N-type portion covering said juxtaposed portion of said first gate electrode, a first P-type portion juxtaposed over said first bar and a second P-type portion juxtaposed over said second bar, forming a first P channel FET device;

said silicon layer having a second N-type portion covering said juxtaposed portion of said second gate electrode and a third P-type portion juxtaposed over said third bar forming a second P channel FET device with said second p-type portion;

said silicon layer having a third N-type portion covering said juxtaposed portion of said third gate electrode and a fourth P-type portion juxtaposed over said fourth bar forming a third P channel FET device with said third P-type portion;

said first diffusion bar connected to a logical output terminal, said fourth diffusion bar connected to ground potential, said second diffusion bar operating as the source of said first N channel FET and the drain of said second N channel FET and said third diffusion bar operating as the source of said second N channel FET and the drain of said third N channel FET;

said first and third P-type portions of said layer connected to said logical output, said second P-type portion connected to a positive potential to operate as the source for both said first and second P channel devices, said fourth P-type portion connected to said positive potential to operate as the source for said third P channel device and said third P-type portion operating as the drain for both said second and third P channel devices.

4. The stacked CMOS device according to claims 1 or 2, characterized in that it is used to form a two-input NAND integrated circuit, comprising:

a first diffusion bar of N-type conductivity in a P-type silicon substrate;

a second diffusion bar of N-type conductivity in said substrate located in spaced, parallel relationship with said first bar forming a first N channel region therebetween;

a third diffusion bar of N-type conductivity in said substrate located in spaced, parallel relationship with said second bar forming a second N channel region therebetween;

a first logical input gate electrode juxtaposed over said first N channel region which is covered by an insulating layer, with said first N channel region forming a first N channel FET device;

a second logical input gate electrode juxtaposed over said second N channel region which is covered by an insulating layer, with said second N channel region forming a second N channel FET device;

a layer of laser annealed silicon having a first N-type portion covering said juxtaposed portion of said first gate electrode, a first P-type portion juxtaposed over said first bar and a second P-type portion juxtaposed over said second bar, forming a first P channel FET device;

said silicon layer having a second N-type portion covering said juxtaposed portion of said second gate electrode and a third P-type portion juxtaposed over said third bar forming a second P channel FET device with said second P-type portion;

said first diffusion bar connected to a logical output terminal, said third diffusion bar connected to ground potential, said second diffusion bar operating as the source of said first N channel FET and the drain of said second N channel FET and said third diffusion bar operating as the source of said second N channel FET;

said first and third P-type portions of said layer connected to said logical output, said second P-type portion connected to a positive potential to operate as the source for both said first and second P channel devices, and said third P-type portion operating as the drain for said second P channel device.

5. The stacked CMOS device according to claims 1 or 2, characterized in that it is used to form a three-input NOR integrated circuit, comprising:

a first diffusion bar of N-type conductivity in a P-type silicon substrate;

a second diffusion bar of N-type conductivity in said substrate located in spaced, parallel relationship with said first bar forming a first N channel region therebetween;

a third diffusion bar of N-type conductivity in said substrate located in spaced, parallel relationship with said second bar forming a second N channel region therebetween;

a fourth diffusion bar of N-type conductivity in said substrate located in spaced, parallel relationship with said third bar forming a third N channel region therebetween;

a first logical input gate electrode juxtaposed over said first N channel region which is covered by an insulating layer, with said first N channel region forming a first N channel FET device;

a second logical input gate electrode juxtaposed over said second N channel region which is covered by an insulating layer, with said second N channel region forming a second N channel FET device;

a third logical input gate electrode juxtaposed over said third N channel region which is covered by an insulating layer with said third N channel region forming a third N channel FET device;

a layer of laser annealed silicon having a first N-type portion covering said juxtaposed portion of said first gate electrode, a first P-type portion juxtaposed over said first bar and a second P-type portion juxtaposed over said second bar, forming a first P channel FET device;

said silicon layer having a second N-type portion covering said juxtaposed portion of said second gate electrode and a third P-type portion juxtaposed over said third bar forming a second P channel FET device with said second P-type portion;

said silicon layer having a third N-type portion covering said juxtaposed portion of said third gate electrode and a fourth P-type portion juxtaposed over said fourth bar forming a third P channel FET device with said third P-type portion;

said first diffusion bar connected to a logical output terminal, said fourth diffusion bar connected to ground potential, said second diffusion bar connected to said ground potential, operating as the source of said first N channel FET and the source of said second N channel FET and said third diffusion bar connected to said output terminal, operating as the drain of said second N channel FET and the drain of said third N channel FET;

said fourth P-type portion of said silicon layer connected to said logical output, said first P-type portion connected to a positive potential to operate as the source for said first P channel device, said second P-type portion operating as the drain for said first P channel device and as the source for said second P channel device and said third P-type portion operating as the drain for said second P channel device and the source for said third P channel device, said fourth P-type portion of said layer operating as the drain of said third P channel device.

6. The stacked CMOS device according to claims 1 or 2, characterized in that it is used to form a two-input NOR integrated circuit, comprising:

a first diffusion bar of N-type conductivity in a P-type silicon substrate;

a second diffusion bar of N-type conductivity in said substrate located in spaced, parallel relationship with said first bar forming a first N channel region therebetween;

a third diffusion bar of N-type conductivity in said substrate located in spaced, parallel relationship with said second bar forming a second N channel region therebetween;

a first logical input gate electrode juxtaposed over said first N channel region which is covered by an insulating layer, with said first N channel region forming a first N channel FET device;

a second logical input gate electrode juxtaposed over said second N channel region which is covered by an insulating layer, with said second N channel region forming a second N channel FET device;

a layer of laser annealed silicon having a first N-type portion covering said juxtaposed portion of said first gate electrode, a first P-type portion juxtaposed over said first bar and a second P-type portion juxtaposed over said second bar, forming a first P channel FET device;

said silicon layer having a second N-type portion covering said juxtaposed portion of said second gate electrode and a third P-type portion juxtaposed over said third bar forming a second P channel FET device with said second P-type portion;

said first diffusion bar connected to a logical output terminal, said second diffusion bar connected to said ground potential, operating as the source of said first N channel FET and the source of said second N channel FET and said third diffusion bar connected to said output terminal operting as the drain of said second N channel FET;

said third P-type portion of said layer connected to said logical output, said first P-type portion connected to a positive potential to operate as the source for said first P channel device, said second P-type portion operating as the drain for said first P channel device and as the source for said second P channel device.

7. The stacked CMOS device according to claims 1 or 2, characterized in that it is used to form a flip-flop integrated circuit, comprising:

a first diffusion bar of N-type conductivity in a P-type silicon substrate;

a second diffusion bar of N-type conductivity in said substrate located in spaced, parallel relationship with said first bar forming a first N channel region therebetween;

a third diffusion bar of N-type conductivity in said substrate located in spaced, parallel relationship with said second bar forming a second N channel region therebetween;

a first logical input gate electrode juxtaposed over said first N channel region which is covered by an insulating layer, with said first N channel region forming a first N channel FET device;

a second logical input gate electrode juxtaposed over said second N channel region which is covered by an insulating layer, with said second N channel region forming a second N channel FET device;

a layer of laser annealed silicon having a first N-type portion covering said juxtaposed portion of said first gate electrode, a first P-type portion juxtaposed over said first bar and a second P-type portion juxtaposed over said second bar, forming a first P channel FET device;

said silicon layer having a second N-type portion covering said juxtaposed portion of said second gate electrode and a third P-type portion juxtaposed over said third bar forming a second P channel FET device with said second P-type portion;

said first diffusion bar connected to a first logical output terminal, said second diffusion bar connected to ground potential, said third diffusion bar connected to a second logical output terminal, said second diffusion bar operating as the source of said first N channel FET and the source of said second N channel FET;

said second P-type portion connected to a positive potential to operate as the source for both said first and second P channel devices, said first diffusion bar connected to said first P-type portion and said third diffusion bar connected to said third P-type portion;

said first gate electrode connected to said third P-type portion and said second gate electrode connected to said first P-type portion.

8. A method for fabricating a stacked CMOS device according to anyone of the claims 1 to 7 comprising the steps of:

depositing a layer of phosphosilicate glass (24, 58) on top of the gate electrode (15, 56) of an N channel field effect transistor device (4) formed in the surface of a monocrystalline silicon substrate (19, 50) having source (16, 60) and drain (17, 62) regions in said substrate on either side of said gate;

depositing a layer of P-type polycrystalline silicon (25, 65) over said phosphosilicate glass layer (24, 58), extending over said source and drain regions and physically contacting a portion of the surface of said monocrystalline silicon substrate (19, 50) of said N channel device (4);

heating said polycrystalline silicon layer (25, 65) including the portion contacting said substrate to a recrystallization temperature;

cooling and recrystallizing said polycrystalline silicon layer (25, 65) into a monocrystalline silicon form having a lattice orientation epitaxially reoriented to the lattice orientation of said monocrystalline semiconductor substrate (19, 50); and

heating said phosphosilicate glass layer (24, 58) so as to diffuse phosphorus atoms from said phosphosilicate glass layer upwardly into said silicon layer (25, 65), forming an N-type region (20, 78) which is juxtaposed with said gate electrode (15, 56) and is self-aligned to said gate electrode, forming the channel region of a P channel field effect transistor device (6), the source and drain regions of which being formed on either side of said channel region;

whereby an upper, P channel field effect transistor device (6) is formed in said silicon layer (25, 65), which shares said gate electrode (15, 56) with said N channel device (4).

9. A method for fabricating a stacked CMOS device according to anyone of the claims 1 to 7 comprising the steps of:

depositing a layer of phosphosilicate glass (24, 58) on top of the gate electrode (15, 56) of an N channel field effect transistor device (4) formed in the surface of a monocrystalline silicon substrate (19, 50) having source (16, 60) and drain (17, 62) regions in said substrate on either side of said gate;

depositing a layer of P-type polycrystalline silicon (25, 65) over said phosphosilicate glass layer (24, 58), extending over said source and drain regions and physically, contacting a portion of the surface of said monocrystalline silicon substrate (19, 50) of said N channel device (4);

heating said polycrystalline silicon layer (25, 65) including the portion contacting said substrate (19, 50) to a recrystallization temperature and heating said phosphosilicate glass layer (24, 58) so as to diffuse phosphorus atoms from said phosphosilicate glass layer upwardly into said silicon layer (25, 65), forming an N-type region (20, 78) which is juxtaposed with said gate electrode (15, 65) and is self-aligned to said gate electrode, forming the channel region of a P channel field effect transistor device (6), the source and drain regions of which being formed on either side of said channel region; and

cooling and recrystallizing said polycrystalline silicon layer (25, 65) into a monocrystalline silicon form having a lattice orientation epitaxially reoriented to the lattice orientation of said monocrystalline semiconductor substrate (19, 50);

whereby an upper, P channel field effect transistor device (6) is formed in said silicon layer (25, 65), which shares said gate electrode (15, 56) with said N channel device (4).

10. The method of claims 8 or 9 wherein said portion of the surface of said substrate (19, 50) contacted by said polycrystalline silicon (25, 65) is said drain (62) of said N channel device (4).

11. The method of claims 8 to 10 comprising the step of:

doping regions in said silicon layer on both sides of said gate of said N channel device (4) as P-type, forming respective source (14, 86) and drain (13, 88) regions of the upper, P channel field effect transistor (6) in said silicon layer (25, 65).

## Patentansprüche

1. Gestapelte CMOS-Vorrichtung, deren individuelle komplementäre FET-Vorrichtungen (4, 6) ein gemeinsames, zwischen den FET's ein-geführtes Gate (15, 16) teilen, folgendes enthaltend:

eine Schicht aus Phosphosilikat-Glas (24, 58) auf der Gate-Elektrode (15, 56) eines N-Kanal-Feldeffekttransistors (4) in der Oberfläche eines monokristallinen Silizium- substrates (19, 50) mit Source-(16, 60)- und Drain-(17, 62)-Zonen im Substrat auf beiden Seiten des Gates;

eine Schicht aus mit Laser wärmebehandeltem Silizium (25, 65) über der Phosphosilikat-Glasschicht (24, 58), die sich über die Source- und Drain-Diffusionen erstreckt und einen Teil der Oberfläche des monokristallinen Siliziumsubstrates (19, 50) der N-Kanalvorrichtung (4) physikalisch berührt;

eine N-Zone (20, 78) in der Silizium-Schicht (25, 65), welche neben der Gate-Elektrode (15, 56) vorgesehen und zu derselben selbstausgerichtet ist und den Kanal einer P-Kanalvorrichtung (6) bildet, deren Source-(14, 86)- und Drain-(13, 88)-Zonen durch P-Teile der Silizium- schicht (25, 65) auf beiden Seiten des Kanals gebildet werden.

2. Gestapelte CMOS-Vorrichtung nach Anspruch 1, worin der genannte Teil des Substrats die Drain (17, 62) des N-Kanal-FET's (4) ist.

3. Gestapelte CMOS-Vorrichtung nach den Ansprüchen 1 oder 2, dadurch gekennzeichnet, dass sie zur Bildung einer integrierten NAND-Schaltung mit drei Eingängen verwendet wird, folgendes enthaltend:

eine erste längliche Diffusionszone der N-Leitfähigkeit in einem P-Silizium-Substrat;

eine zweite längliche Diffusionszone der N-Leitfähigkeit im Substrat beabstandet von und parallel zur ersten Diffusionszone zur Bildung einer ersten dazwischenliegenden N-Kanalzone;

eine dritte längliche Diffusionszone der N-Leitfähigkeit im Substrat beabstandet von und parallel zur zweiten Diffusionszone zur Bildung einer zweiten dazwischenliegenden N-Kanalzone;

eine vierte längliche Diffusionszone der N-Leitfähigkeit im Substrat beabstandet von und parallel zur dritten Diffusionszone zur Bildung einer dritten dazwischenliegenden N-Kanalzone;

eine erste logische, daneben vorgesehene Eingangsgate-Elektrode über der ersten, mit einer Isolierschicht bedeckten N-Kanalzone, wobei die erste N-Kanalzone eine erste N-Kanal-FET-Anordnung bildet;

eine zweite logische, daneben vorgesehene Eingangsgate-Elektrode über der zweiten, mit einer Isolierschicht bedeckten N-Kanalzone, wobei die zweite N-Kanalzone eine zweite N-Kanal-FET-Anordnung bildet;

eine dritte logische, daneben vorgesehene Eingangsgate-Elektrode über der dritten, mit einer Isolierschicht bedeckten N-Kanalzone, wobei die dritte N-Kanalzone eine dritte N-Kanal-FET-Anordnung bildet;

eine Schicht aus mit Laser wärmebehandeltem Silizium, bei der ein erster Teil des N-Typs den daneben liegenden Teil der ersten Gate-Elektrode bedeckt, und bei der ein erster daneben liegender Teil des P-Typs über der ersten länglichen Zone und ein zweiter daneben liegender Teil des P-Typs über der zweiten länglichen Zone eine erste P-Kanal-FET-Vorrichtung bildet;

wobei die Silizium-Schicht einen zweiten Teil des N-Typs aufweist, der den daneben vorgesehenen Teil der zweiten Gateelektrode bedeckt, und wobei ein dritter daneben vorgesehener Teil des P-Typs über der dritten länglichen Zone eine zweite P-Kanal-FET-Vorrichtung mit dem zweiten Teil des P-Typs bildet;

und wobei die Silizium-Schicht einen dritten Teil des T-Typs aufweist, der den daneben vorgesehenen Teil der dritten Gateelektrode bedeckt, und wobei ein vierter daneben vorgesehener Teil des P-Typs über der vierten länglichen Zone eine dritte P-Kanal-FET-Vorrichtung mit dem dritten Teil des P-Typs bildet;

wobei die erste längliche Diffusionszone mit einem logischen Ausgang und die vierte längliche Diffusionszone mit Masse verbunden ist, und wobei die zweite längliche Diffusionszone als Source des ersten N-Kanal-FET's und als Drain des zweiten N-Kanal-FET's geschaltet ist, und wobei die dritte längliche Diffusionszone als Source des zweiten N-Kanal-FET's und als Drain des dritten N-Kanal-FET's geschaltet ist;

und wobei die ersten und dritten Teile des P-Typs der Schicht mit dem logischen Ausgang verbunden sind, und der zweite Teil des P-Typs mit einem positiven Potential zum Betrieb als Source für die ersten und zweiten P-Kanal-Vorrichtungen verbunden ist, und wobei der vierte Teil des P-Typs mit dem positiven Potential zum Betrieb als Source für die dritte P-Kanalvorrichtung verbunden ist, und wobei der dritte Teil des P-Typs als Drain für die zweiten und dritten P-Kanal-Vorrichtungen geschaltet ist.

4. Gestapelte CMOS-Vorrichtung nach den Ansprüchen 1 oder 2, dadurch gekennzeichnet, dass sie zur Bildung einer integrierten NAND-Schaltung mit zwei Eingängen verwendet wird, folgendes enthaltend:

eine erste längliche Diffusionszone der N-Leitfähigkeit in einem P-Silizium-Substrat;

eine zweite längliche Diffusionszone der N-Leitfähigkeit im Substrat beabstandet von und parallel zur ersten Diffusionszone zur Bildung einer ersten dazwischenliegenden N-Kanalzone;

eine dritte längliche Diffusionszone der N-Leitfähigkeit im Substrat beabstandet von und parallel zur zweiten Diffusionszone zur Bildung einer zweiten dazwischenliegenden N-Kanalzone;

eine erste logische, daneben vorgesehene Eingangsgate-Elektrode über der ersten, mit einer Isolierschicht bedecken N-Kanalzone, wobei die erste N-Kanalzone eine erste N-Kanal-FET-Anordnung bildet;

eine zweite logische, daneben vorgesehene Eingangsgate-Elektrode über der zweiten, mit einer Isolierschicht bedeckten N-Kanalzone, wobei die zweite N-Kanalzone eine zweite N-Kanal-FET-Anordnung bildet;

eine Schicht aus mit Laser wärmebehandeltem Silizium, bei der ein erster Teil des N-Typs den daneben liegenden Teil der ersten Gate-Elektrode bedeckt, und bei der ein erster daneben liegender Teil des P-Typs über der ersten länglichen Zone und ein zweiter daneben liegender Teil des P-Typs über der zweiten länglichen Zone eine erste P-Kanal-FET-Vorrichtung bildet;

wobei die Silizium-Schicht einen zweiten Teil des N-Typs aufweist, der den daneben vorgesehenen Teil der zweiten Gateelektrode bedeckt, und wobei ein dritter daneben vorgesehener Teil des P-Typs über der dritten länglichen Zone eine zweite P-Kanal-FET-Vorrichtung mit dem zweiten Teil des P-Typs bildet;

wobei die erste längliche Diffusionszone mit einem logischen Ausgang und die dritte längliche Diffusionszone mit Masse verbunden ist, und wobei die zweite längliche Diffusionszone als Source des ersten N-Kanal-FET's und als Drain des zweiten N-Kanal-FET's geschaltet ist, und wobei die dritte längliche Diffusionszone als Source des zweiten N-Kanal-FET's geschaltet ist;

und wobei die ersten und dritten Teile des P-Typs der Schicht mit dem logischen Ausgang verbunden sind und der zweite Teil des P-Typs mit einem positiven Potential zum Betrieb als Source für die ersten und zweiten P-Kanal-Vorrichtungen verbunden ist, und wobei der dritte Teil des P-Typs als Drain für die zweite P-Kanal-Vorrichtung geschaltet ist.

5. Gestapelte CMOS-Vorrichtung nach den Ansprüchen 1 oder 2, dadurch gekennzeichnet, dass sie zur Bildung einer integrierten NOR-Schaltung mit drei Eingängen verwendet wird, folgendes enthaltend:

eine erste längliche Diffusionszone der N-Leitfähigkeit in einem P-Silizium-Substrat;

eine zweite längliche Diffusionszone der N-Leitfähigkeit im Substrat beabstandet von und parallel zur ersten Diffusionszone zur Bildung einer ersten dazwischenliegenden N-Kanalzone;

eine dritte längliche Diffusionszone der N-Leitfähigkeit im Substrat beabstandet von und parallel zur zweiten Diffusionszone zur Bildung einer zweiten dazwischenliegenden N-Kanalzone;

eine vierte längliche Diffusionszone der N-Leitfähigkeit im Substrat beabstandet von und parallel zur dritten Diffusionszone zur Bildung einer dritten dazwischenliegenden N-Kanalzone;

eine erste logische, daneben vorgesehene Eingangsgate-Elektrode über der ersten, mit einer Isolierschicht bedecken N-Kanalzone, wobei die erste N-Kanalzone eine erste N-Kanal-FET-Anordnung bildet;

eine zweite logische, daneben vorgesehene Eingangsgate-Elektrode über der zweiten, mit einer Isolierschicht bedeckten N-Kanalzone, wobei die zweite N-Kanalzone eine zweite N-Kanal-FET-Anordnung bildet;

eine dritte logische, daneben vorgesehene Eingangsgate-Elektrode über der dritten, mit einer Isolierschicht bedeckten N-Kanalzone, wobei die dritte N-Kanalzone eine dritte N-Kanal-FET-Anordnung bildet;

eine Schicht aus mit Laser wärmebehandeltem Silizium, bei der ein erster Teil des N-Typs den daneben liegenden Teil der ersten Gate-Elektrode bedeckt, und bei der ein erster daneben liegender Teil des P-Typs über der ersten länglichen Zone und ein zweiter daneben liegender Teil des P-Typs über der zweiten länglichen Zone eine erste P-Kanal-FET-Vorrichtung bildet;

wobei die Silizium-Schicht einen zweiten Teil des N-Typs aufweist, der den daneben vorgesehenen Teil der zweiten Gateelektrode bedeckt, und wobei ein dritter daneben vorgesehener Teil des P-Typs über der dritten länglichen Zone eine zweite P-Kanal-FET-Vorrichtung mit dem zweiten Teil des P-Typs bildet;

und wobei die Silizium-Schicht einen dritten Teil des T-Typs aufweist, der den daneben vorgesehenen Teil der dritten Gateelektrode bedeckt, und wobei ein vierter daneben vorgesehener Teil des P-Typs über der vierten länglichen Zone eine dritte P-Kanal-FET-Vorrichtung mit dem dritten Teil des P-Typs bildet;

wobei die erste längliche Diffusionszone mit einem logischen Ausgang und die vierte längliche Diffusionszone mit Masse verbunden ist, und wobei die zweite längliche Diffusionszone als Source des ersten N-Kanal-FET's und als Drain des zweiten N-Kanal-FET's geschaltet ist, und wobei die dritte längliche Diffusionszone als Source des zweiten N-Kanal-FET's und als Drain des dritten N-Kanal-FET's geschaltet ist;

und wobei die ersten und dritten Teile des P-Typs der Schicht mit dem logischen Ausgang verbunden sind, und der zweite Teil des P-Typs mit einem positiven Potential zum Betrieb als Source für die ersten und zweiten P-Kanal-Vorrichtungen verbunden ist, und wobei der vierte Teil des P-Typs mit dem positiven Potential zum Betrieb als Source für die dritte P-Kanalvorrichtung verbunden ist, und wobei der dritte Teil des P-Typs als Drain für die zweiten und dritten P-Kanal-Vorrichtungen geschaltet ist,

wobei die erste längliche Diffusionszone mit einem logischen Ausgang und die vierte längliche Diffusionszone mit Masse verbunden ist, und wobei die zweite längliche, mit Masse verbundene Diffusionszone als Source des ersten N-Kanal-FET und als Source des zweiten N-Kanal-FET geschaltet ist, und wobei die dritte längliche, mit dem Ausgang verbundene Diffusionszone als Drain des zweiten N-Kanal-FET und als Drain des dritten N-Kanal-FET geschaltet ist;

und wobei der vierte Teil des P-Typs der Siliziumschicht als logischer Ausgang geschaltet und der erste Teil des P-Typs als positives Potential geschaltet ist zum Betrieb als Source for die erste P-Kanal-Vorrichtung, und wobei der zweite Teil des P-Typs als Drain für die erste P-Kanal-Vorrichtung und als Source für die zweite P-Kanal-Vorrichtung geschaltet ist, und der dritte Teil des P-Typs als Drain für die zweite P-Kanal-Vorrichtung und als Source für die dritte P-Kanal-Vorrichtung geschaltet ist, und wobei der vierte Teil des P-Typs der Schicht als Drain der dritten P-Kanal-Vorrichtung geschaltet ist.

6. Gestapelte CMOS-Vorrichtung nach den Ansprüchen 1 oder 2, dadurch gekennzeichnet, dass sie zur Bildung einer integrierten NOR-Schaltung mit drei Eingängen verwendet wird, folgendes enthaltend:

eine erste ängliche Diffusionszone der N-Leitfähigkeit in einem P-Silizium-Substrat;

eine zweite längliche Diffusionszone der N-Leitfähigkeit im Substrat beabstandet von und parallel zur ersten Diffusionszone zur Bildung einer ersten dazwischenliegenden N-Kanalzone;

eine dritte längliche Diffusionszone der N-Leitfähigkeit im Substrat beabstandet von und parallel zur zweiten Diffusionszone zur Bildung einer zweiten dazwischenliegenden N-Kanalzone;

eine erste logische, daneben vorgesehene Eingangsgate-Elektrode über der ersten, mit einer Isolierschicht bedecken N-Kanalzone, wobei die erste N-Kanalzone eine erste N-Kanal-FET-Anordnung bildet;

eine zweite logische, daneben vorgesehene Eingangsgate-Elektrode über der zweiten, mit einer Isolierschicht bedeckten N-Kanalzone, wobei die zweite N-Kanalzone eine zweite N-Kanal-FET-Anordnung bildet;

eine Schicht aus mit Laser wärmebehandeltem Silizium, bei der ein erster Teil des N-Typs den daneben liegenden Teil der ersten Gate-Elektrode bedeckt, und bei der ein erster daneben liegender Teil des P-Typs über der ersten länglichen Zone und ein zweiter daneben liegender Teil des P-Typs über der zweiten länglichen Zone eine erste P-Kanal-FET-Vorrichtung bildet;

wobei die Silizium-Schicht einen zweiten Teil des N-Typs aufweist, der den daneben vorgesehenen Teil der zweiten Gateelektrode bedeckt, und wobei ein dritter daneben vorgesehener Teil des P-Typs über der dritten länglichen Zone eine zweite P-Kanal-FET-Vorrichtung mit dem zweiten Teil des P-Typs bildet;

und wobei die Silizium-Schicht einen dritten Teil des T-Typs aufweist, der den daneben vorgesehenen Teil der dritten Gateelektrode bedeckt, und wobei ein vierter daneben vorgesehener Teil des P-Typs über der vierten länglichen Zone eine dritte P-Kanal-FET-Vorrichtung mit dem dritten Teil des P-Typs bildet;

wobei die erste längliche Diffusionszone mit einem logischen Ausgang und die vierte längliche Diffusionszone mit Masse verbunden ist, und wobei die zweite längliche Diffusionszone als Source des ersten N-Kanal-FET's und als Drain des zweiten N-Kanal-FET's geschaltet ist, und wobei die dritte längliche Diffusionszone als Source des zweiten N-Kanal-FET's und als Drain des dritten N-Kanal-FET's geschaltet ist;

und wobei die ersten und dritten Teile des P-Typs der Schicht mit dem logischen Ausgang verbunden sind, und der zweite Teil des P-Typs mit einem positiven Potential zum Betrieb als Source für die ersten und zweiten P-Kanal-Vorrichtungen verbunden ist, und wobei der vierte Teil des P-Typs mit dem positiven Potential zum Betrieb als Source für die dritte P-Kanalvorrichtung verbunden ist, und wobei der dritte Teil des P-Typs als Drain für die zweiten und dritten P-Kanal-Vorrichtungen geschaltet ist,

wobei die erste längliche Diffusionszone mit einem logischen Ausgang und die vierte längliche Diffusionszone mit Masse verbunden ist, und wobei die zweite längliche, mit Masse verbundene Diffusionszone als Source des ersten N-Kanal-FET und als Source des zweiten N-Kanal-FET geschaltet ist, und wobei die dritte längliche, mit dem Ausgang verbundene Diffusionszone als Drain des zweiten N-Kanal-FET und als Drain des dritten N-Kanal-FET geschaltet ist;

und wobei der vierte Teil des P-Typs der Siliziumschicht als logischer Ausgang geschaltet und der erste Teil des P-Typs als positives Potential geschaltet ist zum Betrieb als Source for die erste P-Kanal-Vorrichtung, und wobei der zweite Teil des P-Typs als Drain für die erste P-Kanal-Vorrichtung und als Source für die zweite P-Kanal-Vorrichtung geschaltet ist, und der dritte Teil des P-Typs als Drain für die zweite P-Kanal-Vorrichtung und als Source für die dritte P-Kanal-Vorrichtung geschaltet ist, und wobei der vierte Teil des P-Typs der Schicht als Drain der dritten P-Kanal-Vorrichtung geschaltet ist,

wobei die erste längliche Diffusionszone mit einem logischen Ausgang und die zweite längliche, mit Masse verbundene Diffusionszone als Source des ersten N-Kanal-FET's und als Source des zweiten N-Kanal-FET's geschaltet ist, und dass die dritte längliche, mit dem Ausgang verbundene Diffusionszone als Drain des zweiten N-Kanal-FET's geschaltet ist.

7. Gestapelte CMOS-Vorrichtung nach den Ansprüchen 1 oder 2, dadurch gekennzeichnet, dass sie zur Bildung einer integrierten Flipflop- Schaltung verwendet wird, folgendes enthaltend:

eine erste längliche Diffusionszone der N-Leitfähigkeit in einem P-Silizium-Substrat;

eine zweite längliche Diffusionszone der N-Leitfähigkeit im Substrat beabstandet von und parallel zur ersten Diffusionszone zur Bildung einer ersten dazwischenliegenden N-Kanalzone;

eine dritte längliche Diffusionszone der N-Leitfähigkeit im Substrat beabstandet von und parallel zur zweiten Diffusionszone zur Bildung einer zweiten dazwischenliegenden N-Kanalzone;

eine erste logische, daneben vorgesehene Eingangsgate-Elektrode über der ersten, mit einer Isolierschicht bedecken N-Kanalzone, wobei die erste N-Kanalzone eine erste N-Kanal-FET-Anordnung bildet;

eine zweite logische, daneben vorgesehene Eingangsgate-Elektrode über der zweiten, mit einer Isolierschicht bedeckten N-Kanalzone, wobei die zweite N-Kanalzone eine zweite N-Kanal-FET-Anordnung bildet;

eine Schicht aus mit Laser wärmebehandeltem Silizium, bei der ein erster Teil des N-Typs den daneben liegenden Teil der ersten Gate-Elektrode bedeckt, und bei der ein erster daneben liegender Teil des P-Typs über der ersten länglichen Zone und ein zweiter daneben liegender Teil des P-Typs über der zweiten länglichen Zone eine erste P-Kanal-FET-Vorrichtung bildet;

wobei die Silizium-Schicht einen zweiten Teil des N-Typs aufweist, der den daneben vorgesehenen Teil der zweiten Gateelektrode bedeckt, und wobei ein dritter daneben vorgesehener Teil des P-Typs über der dritten länglichen Zone eine zweite P-Kanal-FET-Vorrichtung mit dem zweiten Teil des P-Typs bildet;

wobei die erste längliche Diffusionszone mit einem ersten logischen Ausgang, die zweite längliche Diffusionszone mit Masse und die dritte längliche Diffusionszone mit einem zweiten logischen Ausgang verbunden ist, und wobei die zweite längliche Diffusionszone als Source des ersten N-Kanal-FET und als Source des zweiten N-Kanal-FET geschaltet ist;

und wobei der zweite Teil des P-Typs mit einem positiven Potential verbunden ist zum Betrieb als Source für die ersten und zweiten P-Kanal-Vorrichtungen und die erste längliche Diffusionszone mit dem ersten Teil des P-Typs und die dritte längliche Diffusionszone mit dem dritten Teil des P-Typs,

und wobei die erste Gateelektrode mit dem dritten Teil des P-Typs und die zweite Gateelektrode mit dem ersten Teil des P-Typs verbunden ist.

8. Verfahren zum Herstellen einer gestapelten CMOS-Vorrichtung nach einem der Ansprüche 1—7, folgende Schritte umfassend:

Aufbringen einer Schicht aus Phosphosilikat-Glas (24, 58) auf der Gate-Elektrode (15, 56) eines N-Kanal-Feldeffekttransistors (4) in der Oberfläche eines monokristallinen Siliziumsubstrats (19, 50) mit Source-(16, 60)- und Drain-(17,26)-Zonen im Substrat auf beiden Seiten des Gates; Aufbringen einer Schicht aus P-polykristallinem Silizium (25, 65) über der Phosphosilikat-Glasschicht (24, 58), die sich über die Source und Drainzonen erstreckt und einen Teil der Oberfläche des monokristallinen Siliziumsubstrates (19, 50) der N-Kanalvorrichtung (4) physikalisch berührt;

Erwärmen der polykristallinen Siliziumschicht (25, 65) einschliesslich des das Substrat berührenden Teils auf eine Rekristallisierungstemperatur;

Kühlen und Rekristallisieren der polykristallinen Siliziumschicht (25, 65) in monokristalline Siliziumform, mit einer Gitterorientierung, welche zu der des monokristallinen Halbleitersubstrates (19, 50) epitaxial rückorientiert ist; und

Erwärmen der Phosphosilikat-Glasschicht (24, 58), um Phosphoratome aus der Phosphosilikat-Glasschicht nach oben in die Siliziumschicht (25, 65) zu diffundieren und eine N-Zone (20, 78) zu bilden, welche neben der Gateelektrode (15, 56) liegt und mit derselben selbstausgerichtet ist und die Kanalzone einer P-Kanal-FET-Vorrichtung (6) bildet, deren Source- und Drainzonen auf beiden Seiten der Kanalzone vorgesehen sind;

so daß eine obere P-Kanal-FET-Vorrichtung (6) in der Siliziumschicht (25, 65) entsteht, welche die Gateelektrode (15, 56) mit der N-Kanal-Vorrichtung (4) teilt.

9. Verfahren zum Herstellen einer gestapelten CMOS-Vorrichtung nach einem der Ansprüche 1—7, folgende Schritte umfassend:

Aufbringen einer Schicht aus Phosphosilikat-Glas (24, 58) auf der Gate-Elektrode (15, 56) eines N-Kanal-Feldeffekttransistors (4) in der Oberfläche eines monokristallinen Siliziumsubstrats (19, 50) mit Source-(16, 60)und Drain-(17, 26)-Zonen im Substrat auf beiden Seiten des Gates; Aufbringen einer Schicht aus P-polykristallinem Silizium (25, 65) über der Phosphosilikat-Glasschicht (24, 58), die sich über die Source- und Drainzonen erstreckt und einen Teil der Oberfläche des monokristallinen Siliziumsubstrates (19, 50) der N-Kanalvorrichtung (4) physikalisch berührt;

Erwärmen der polykristallinen Siliziumschicht (25, 65) einschliesslich des das Substrat berührenden Teils auf eine Rekristallisierungstemperatur;

Kühlen und Rekristallisieren der polykristallinen Siliziumschicht (25, 65) in monokristalline Siliziumform, mit einer Gitterorientierung, welche zu der des monokristallinen Halbleitersubstrates (19, 50) epitaxial rückorientiert ist; und

Erwärmen der polykristallinen Siliziumschicht (25, 65) einschliesslich des das Substrat (19, 50) berührenden Teiles auf eine Rekristallisierungstemperatur, und Erwärmen der Phosphosilikat-Glasschicht (24, 58), um Phosphoratome aus der Phosphosilikat-Glasschicht nach oben in die Siliziumschicht (25, 65) zu diffundieren und eine N-Zone (20, 78) zu bilden, welche neben der Gateelektrode (15, 56) liegt und mit derselben selbstausgerichtet ist und die Kanalzone einer P-Kanal-FET-Vorrichtung (6) bildet, deren Sourceu- Drainzonen auf beiden Seiten der Kanalzone vorgesehen sind;

Kühlen und Rekristallisieren der polykristallinen Siliziumschicht (25, 65) in monokristalline Siliziumform, mit einer Gitterorientierung, welche zu der des monokristallinen Halbleitersubstrats (19, 50) epitaxial rückorientiert ist;

sodass eine obere P-Kanal-FET-Vorrichtung (6) in der Siliziumschicht (25, 65) entsteht, welche die Gateelektrode (15, 56) mit der N-Kanal-Vorrichtung teilt.

10. Verfahren nach den Ansprüchen 8 oder 9, worin der von dem poly- kristallinen Silizium (25, 65) berührte Teil der Oberfläche des Substrats (19, 50) die Drain (62) der N-Kanal-Vorrichtung (4) ist.

11. Verfahren nach den Ansprüchen 8 bis 10, folgenden Schritt umfassend:

Dotieren von Zonen in der Siliziumschicht auf beiden Seiten des Gates der N-Kanal-Vorrichtung (4) als P-Typ und Bilden entsprechender Source (14, 86)- und Drain-(13, 88)-Zonen des oberen P-Kanal-Feldeffekttransistors (6) in der Siliziumschicht (25, 65).

**Revendications**

1. Dispositif CMOS empilé dont les dispositifs FET complémentaires individuels (4, 6) partagent une grille commune (15, 56) prise en sandwich entre eux, comprenant:

une couche de verre au phosphosilicate (24, 58) au-dessus de l'électrode de grille (15, 56) d'un dispositif de transistor à effet de champ à canal N (4) formé dans la surface d'un substrat de silicium monocristallin (19, 50) comprenant des régions de source (16, 60) et de drain (17, 62) dans le substrat de part et d'autre de la grille;

une couche de silicium recuit au laser (25, 65) au-dessus de la couche de verre au phosphosilicate (24, 58) s'étendant au-dessus des diffusions de source et de drain et en contact physique avec une partie de la surface du substrat de silicium monocristallin (19, 50) du dispositif à canal N (4);

une région de type N (20, 78) dans ladite couche de silicium (25, 65), qui est juxtaposée à l'électrode de grille (15, 56) et est autoalignée avec cette électrode de grille, formant le canal d'un dispositif à canal P (6), dont les régions de source (14, 86) et de drain (13, 88) sont constituées de parties de type P de la couche de silicium (25, 65) de part et d'autre du canal.

2. Dispositif CMOS empilé selon la revendication 1, dans lequel ladite partie du substrat est le drain (17, 62) du dispositif FET à canal N (4).

3. Dispositif CMOS empilé selon la revendication 1 ou 2, caractérisé en ce qu'il est utilisé pour former un circuit intégré NON ET à trois entrées, comprenant:

une première bande de diffusion à conductivité de type N dans un substrat de silicium de type P;

une seconde bande de diffusion à conductivité de type N dans le substrat disposée de façon parallèle et espacée par rapport à la première bande, formant une première région de canal de type N entre elles;

une troisième bande de diffusion à conductivité de type N dans le substrat disposée de façon parallèle et espacée par rapport à la seconde bande formant une seconde région de canal de type N entre elles;

une quatrième bande de diffusion à conductivité de type N dans le substrat disposée de façon parallèle et espacée par rapport à la troisième bande, formant une troisième région de canal de type N entre elles;

une première électrode de grille d'entrée logique juxtaposée au-dessus de la première région à canal N qui est recouverte d'une couche isolante, la première région de canal N formant un premier dispositif FET à canal N;

une seconde électrode de grille d'entrée logique juxtaposée au dessus de la seconde région de canal N qui est recouverte d'une couche isolante, la seconde région de canal N formant un second dispositif FET à canal N;

une troisième électrode de grille d'entrée logique juxtaposée au-dessus de la troisième région de canal N qui est recouverte d'une couche isolante, la troisième région de canal N formant un troisième dispositif FET à canal N;

une couche de silicium recuite au laser comprenant une première partie de type N recouvrant ladite partie juxtaposée de la première électrode de grille, une première partie de type P juxtaposée au dessus de la première bande et une seconde partie de type P juxtaposée au-dessus de la seconde bande, formant un premier dispositif FET à canal P;

ladite couche de silicium comprenant une seconde partie de type N recouvrant la partie juxtaposée de la seconde électrode de grille et une troisième partie de type P recouvrant la troisième bande formant un second dispositif FET à canal P avec la seconde partie de type P;

ladite couche de silicium comprenant une troisième partie de type N recouvrant la partie juxtaposée de la troisième électrode de grille et une quatrième partie de type P juxtaposée au-dessus de la quatrième bande formant un troisième dispositif FET à canal P avec la troisième partie de type P;

la première bande de diffusion étant connectée à une borne de sortie logique, la quatrième bande de diffusion étant connectée au potentiel de la masse, la seconde bande de diffusion agissant en temps que source du premier FET à canal N et que drain du second FET à canal N et la troisième bande de diffusion agissant en temps que source du second FET à canal N et que drain du troisième FET à canal N;

les première et troisième parties de type P de ladite couche étant connectées à la sortie logique, la seconde partie de type P étant connectée à un potentiel positif pour agir en tant que source pour les premier et second dispositifs à canal P, la quatrième partie de type p étant connectée au potentiel positif pour agir en tant que source pour le troisième dispositif à canal P et la troisième partie de type P agissant en tant que drain pour les deuxième et troisième dispositifs à canal P.

4. Dispositif CMOS empilé selon la revendication 1 ou 2, caractérisé en ce qu'il est utilisé pour former un circuit intégré NON ET à deux entrées, comprenant:

une première bande de diffusion à conductivité de type N dans un substrat de silicium de type P;

une seconde bande de diffusion à conductivité de type N dans le substrat disposée de façon parallèle et espacée par rapport à la première bande, formant une première région de canal de type N entre elles;

une troisième bande de diffusion à conductivité de type N dans le substrat disposée de façon parallèle et espacée par rapport à la seconde bande formant une seconde région de canal de type N entre elles;

une première électrode de grille d'entrée logique juxtaposée au-dessus de la première région à canal N qui est recouverte d'une couche isolante, la première région de canal N formant un premier dispositif FET à canal N;

une seconde électrode de grille d'entrée logique juxtaposée au dessus de la seconde région de canal N qui est recouverte d'une couche isolante, la seconde région de canal N formant un second dispositif FET à canal N;

une couche de silicium recuite au laser comprenant une première partie de type N recouvrant ladite partie juxtaposée de la première électrode de grille, une première partie de type P juxtaposée au dessus de la première bande et une seconde partie de type P juxtaposée au-dessus de la seconde bande, formant un premier dispositif FET à canal P;

ladite couche de silicium comprenant une seconde partie de type N recouvrant la partie juxtaposée de la seconde électrode de grille et une troisième partie de type P recouvrant la troisième bande formant un second dispositif FET à canal P avec la seconde partie de type P;

la première bande de diffusion étant connectée à une borne de sortie logique, la troisième bande de diffusion étant connectée au potentiel de la masse, la seconde bande de diffusion agissant en temps que source du premier FET à canal N et que drain du second FET à canal N et la troisième bande de diffusion agissant en temps que source du second FET à canal N;

les première et troisième parties de type P de ladite couche étant connectées à la sortie logique, la seconde partie de type P étant connectée à un potentiel positif pour agir en tant que source pour les premier et second dispositifs à canal P, et la troisième partie de type P agissant en tant que drain pour le deuxième dispositif à canal P.

5. Dispositif CMOS empilé selon la revendication 1 ou 2, caractérisé en ce qu'il est utilisé pour former un circuit intégré NON OU à trois entrées, comprenant:

une première bande de diffusion à conductivité de type N dans un substrat de silicium de type P;

une seconde bande de diffusion à conductivité de type N dans le substrat disposée de façon parallèle et espacée par rapport à la première bande, formant une première région de canal de type N entre elles;

une troisième bande de diffusion à conductivité de type N dans le substrat disposée de façon parallèle et espacée par rapàport à seconde bande formant une seconde région de canal de type N entre elles;

une quatrième bande de diffusion à conductivité de type N dans le substrat disposée de façon parallèle et espacée par rapport à la troisième bande, formant une troisième région de canal de type N entre elles;

une première électrode de grille d'entrée logique juxtaposée au-dessus de la première région à canal N qui est recouverte d'une couche isolante, la première région de canal N formant un premier dispositif FET à canal N;

une seconde électrode de grille d'entrée logique juxtaposée au dessus de la seconde région de canal N qui est recouverte d'une couche isolante, la seconde région de canal N formant un second dispositif FET à canal N;

une troisième électrode de grille d'entrée logique juxtaposée au-dessus de la troisième région de canal N qui est recouverte d'une couche isolante, la troisième région de canal N formant un troisième dispositif FET à canal N;

une couche de silicium recuite au laser comprenant une première partie de type N recouvrant ladite partie juxtaposée de la première électrode de grille, une première partie de type P juxtaposée au dessus de la première bande et une seconde partie de type P juxtaposée au-dessus de la seconde bande, formant un premier dispositif FET à canal P;

ladite couche de silicium comprenant une seconde partie de type N recouvrant la partie juxtaposée de la seconde électrode de grille et une troisième partie de type P recouvrant la troisième bande formant un second dispositif FET à canal P avec la seconde partie de type P;

ladite couche de silicium comprenant une troisième partie de type N recouvrant la partie juxtaposée de la troisième électrode de grille et une quatrième partie de type P juxtaposée au-dessus de la quatrième bande formant un troisième dispositif FET à canal P avec la troisième partie de type P;

la première bande de diffusion étant connectée à une borne de sortie logique, la quatrième bande de diffusion étant connectée au potentiel de la masse, la seconde bande de diffusion étant connectée au potentiel de la masse, agissant en tant que source du premier FET à canal N et que source du second FET à canal N, et la troisième bande de diffusion étant connectée à la borne de sortie, fonctionnant en tant que drain du second FET à canal N et que drain du troisième FET à canal N;

la quatrième partie de la couche de silicium étant connectée à ladite sortie logique, la première partie de type P étant connectée à un potentiel positif pour agir en tant que source du premier dispositif à canal P, la seconde partie de type P agissant en tant que drain pour le premier dispositif à canal P et en tant que source pour le second dispositif à canal P, et la troisième partie à canal P agissant en tant que drain pour le second dispositif à canal P et que source pour le troisième dispositif à canal P, la quatrième partie de type P de la couche agissant en tant que drain du troisième dispositif à canal P.

6. Dispositif CMOS empilé selon l'une des revendications 1 ou 2, caractérisé en ce qu'il est utilisé pour former un circuit intégré NON OU à deux entrées, comprenant:

une première bande de diffusion à conductivité de type N dans un substrat de silicium de type P;

une seconde bande de diffusion à conductivité de type N dans le substrat disposée de façon parallèle et espacée par rapport à la première bande, formant une première région de canal de type N entre elles;

une troisième bande de diffusion à conductivité de type N dans le substrat disposée de façon parallèle et espacée par rapport à la seconde bande formant une seconde région de canal de type N entre elles;

une première électrode de grille d'entrée logique juxtaposée au-dessus de la première région à canal N qui est recouverte d'une couche isolante, la première région de canal N formant un premier dispositif FET à canal N;

une seconde électrode de grille d'entrée logique juxtaposée au dessus de la seconde région de canal N qui est recouverte d'une couche isolante, la seconde région de canal N formant un second dispositif FET à canal N;

une couche de silicium recuite au laser comprenant une première partie de type N recouvrant ladite partie juxtaposée de la première électrode de grille, une première partie de type P juxtaposée au dessus de la première bande et une seconde partie de type P juxtaposée au-dessus de la seconde bande, formant un premier dispositif FET à canal P;

ladite couche de silicium comprenant une seconde partie de type N recouvrant la partie juxtaposée de la seconde électrode de grille et une troisième partie de type P recouvrant la troisième bande formant un second dispositif FET à canal P avec la seconde partie de type P;

la première bande de diffusion étant connectée à une borne de sortie logique, la seconde bande de diffusion étant connectée au potentiel de la masse, agissant en tant que source du premier FET à canal N et que source du second FET à canal N, et la troisième bande de diffusion étant connectée à la borne de sortie, fonctionnant en tant que drain du second FET à canal N;

la troisième partie de type P de la couche de silicium étant connectée à ladite sortie logique, la première partie de type P étant connectée à un potentiel positif pour agir en tant que source du premier dispositif à canal P, la seconde partie de type P agissant en tant que drain pour le premier dispositif à canal P et en tant que source pour le second dispositif à canal P.

7. Dispositif CMOS empilé selon l'une des revendications 1 ou 2, caractérisé en ce qu'il est utilisé pour former un circuit intégré de bascule, comprenant:

une première bande de diffusion à conductivité de type N dans un substrat de silicium de type P;

une seconde bande de diffusion à conductivité de type N dans le substrat disposée de façon parallèle et espacée par rapport à la première bande, formant une première région de canal de type N entre elles;

une troisième bande de diffusion à conductivité de type N dans le substrat disposée de façon parallèle et espacée par rapport à la seconde bande formant une seconde région de canal de type N entre elles;

une première électrode de grille d'entrée logique juxtaposée au-dessus de la première région à canal N qui est recouverte d'une couche isolante, la première région de canal N formant un premier dispositif FET à canal N;

une seconde électrode de grille d'entrée logique juxtaposée au dessus de la seconde région de canal N qui est recouverte d'une couche isolante, la seconde région de canal N formant un second dispositif FET à canal N;

une couche de silicium recuite au laser comprenant une première partie de type N recouvrant ladite partie juxtaposée de la première électrode de grille, une première partie de type P juxtaposée au dessus de la premiè rebande et une seconde partie de type P juxtaposée au-dessus de la seconde bande, formant un premier dispositif FET à canal P;

ladite couche de silicium comprenant une seconde partie de type N recouvrant la partie juxtaposée de la seconde électrode de grille et une troisième partie de type P recouvrant la troisième bande formant un second dispositif FET à canal P avec la seconde partie de type P;

la première bande de diffusion étant connectée à une première borne de sortie logique, la seconde bande de diffusion étant connectée au potentiel de la masse, la troisième bande de diffusion étant connectée à une seconde borne de sortie logique, la seconde bande de diffusion agissant en tant que source du premier FET à canal N et que source du second FET à canal N;

la seconde partie de type P étant connectée à un potentiel positif pour agir en tant que source pour les premier et second dispositifs à canal P, la première bande de diffusion étant connectée à la première partie de type P et la troisième bande de diffusion étant connectée à la troisième partie de type P;

la première électrode de grille étant connectée à la troisième partie de type P et la seconde électrode de grille étant connectée à la première partie de type P.

8. Procédé de fabrication d'un dispositif CMOS empilé selon l'une des revendications 1 à 7, comprenant les étapes suivantes:

déposer une couche de verre au phosphosilicate (24, 58) sur l'électrode de grille (15, 56) d'un dispositif de transistor à effet de champ à canal N (4) formé dans la surface d'un substrat de silicium monocristallin (19, 50) ayant des régions de source (16, 60) et de drain (17, 62) dans le substrat des deux côtés de la grille;

déposer une couche de silicium polycristallin de type P (25, 65) sur la couche de verre au phosphosilicate (24, 58) s'étendant sur les régions de source et de drain et en contact physique avec une partie de la surface du substrat de silicium monocristallin (19, 50) du dispositif à canal N (4);

chauffer la couche de silicium polycristallin (25, 65), y compris la partie en contact avec le substrat jusqu'à une température de recristallisation;

refroidir et recristalliser la couche de silicium polycristallin (25, 65) ayant une orientation de réseau réorientée épitaxialement avec l'orientation de réseau du substrat semiconducteur monocristallin (19, 50); et

chauffer la couche de verre au phosphosilicate (24, 58) de façon à faire diffuser des atomes de phosphore à partir de la couche de verre au phosphosilicate vers le haut dans la couche de silicium (25, 65) formant une région de type N (20, 78) qui est juxtaposée à l'électrode de grille (15, 56) et est autoalignée avec l'électrode de grille, formant la région de canal d'un dispositif de transistor à effet de champ à canal P (6) dont les régions de source et de drain sont formées des deux côtés de la région de canal;

d'où il résulte qu'un dispositif supérieur de transistor à effet de champ à canal P (6) est formé dans la couche de silicium (25, 65) et partage ladite électrode de grille (15, 56) avec le dispositif à canal N (4).

9. Procédé de fabrication d'un dispositif CMOS empilé selon l'une quelconque des revendications 1 à 7, comprenant les étapes suivantes:

déposer une couche de verre au phosphosilicate (24, 58) sur l'électrode de grille (15, 56) d'un dispositif de transistor à effet de champ à canal N (4) formé dans la surface d'un substrat de silicium monocristallin (19, 50) ayant des régions de source (16, 60) et de drain (17, 62) dans le substrat des deux côtés de la grille;

déposer une couche de silicium polycristallin de type P (25, 65) sur la couche de verre au phosphosilicate (24, 58) s'étendant sur les régions de source et de drain et en contact physique avec une partie de la surface du substrat de silicium monocristallin (19, 50) du dispositif à canal N (4);

chauffer la couche de silicium polycristallin (25, 65), y compris la partie en contact avec le substrat (19, 50) jusqu'à une température de recristallisation et chauffer la couche de verre au phosphosilicate (24, 58) de façon à faire diffuser les atomes de phosphore en provenance de la couche de verre de phosphosilicate vers le haut dans la couche de silicium (25, 65), formant une région de type N (20, 78) qui est juxtaposée à ladite électrode de grille (15, 65) et est autoalignée avec l'électrode de grille, formant la région de canal d'un dispositif de transistor à effet de champ à canal P (6) dont les régions de source et de drain sont formées de part et d'autre de la région de canal; et

refroidir et recristalliser la couche de silicium polycristallin (25, 65) ayant une orientation de réseau réorientée épitaxialement avec l'orientation de réseau du substrat semiconducteur monocristallin (19, 50);

d'où il résulte qu'un dispositif supérieur de transistor à effet de champ à canal P (6) est formé dans la couche de silicium (25, 65) et partage ladite électrode de grille (15, 56) avec le dispositif à canal N (4).

10. Procédé selon l'une des revendications 8 ou 9, dans lequel la partie de la surface du substrat (19, 50) en contact avec le silicium polycristallin (25, 65) est le drain (62) du dispositif à canal N (4).

11. Procédé selon les revendications 8 à 10, comprenant l'étape suivante:

doper des régions dans la couche de silicium des deux côtés de la grille du dispositif à canal N (4) en tant que régions de type P formant respectivement la source (14, 86) et le drain (13, 88) du transistor à effet de champ à canal P supérieur (6) dans ladite couche de silicium (25, 65).

0 066 068

FIG. 1
(PRIOR ART)

FIG. 2

FIG. 3A

FIG. 3B

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18A

FIG. 18B

FIG. 19

FIG. 20

FIG. 21

8

FIG. 22
(PRIOR ART)

FIG. 23

FIG. 25 (PRIOR ART)

FIG. 26

FIG. 24

FIG. 27

FIG. 28 (PRIOR ART)

FIG. 29

FIG. 30

160     101d     110

N+                 ▨          } OUT

161 → P
162
N+

163 → P
164
N+

165 → P
166
N+          ⊠

101e

**FIG. 31**

90a
                              IN
100

90b
                              IN
102

90c
                              IN
104

**FIG. 32**

168    150    110

P+    ⊠

169 ⟶    N

⊠—101a    P+    154

155 ⟶    N

152

156    P+    ⊠

157 ⟶    N

158

⊠
101b

**FIG. 33**

101c

108    106

**FIG. 34**

170     115e     124

N+     ⊠     OUT

171 → P     172     115a

N+     ⊠

173 → P     174     115d

N+     ⊠

175 → P     176     115b

N+     ⊠

**FIG. 35**

120

118

116

**FIG. 36**

115f     178

⊠    P+

179 → N     180

P+

181 → N     182

P+

183 → N     184     115c

P+     ⊠

**FIG. 37**

FIG. 38

FIG. 39

FIG. 40

FIG. 41

FIG. 42

FIG. 43